# EUROPÄISCHE PATENTSCHRIFT

(11) **EP 0 624 826 B1**
(45) Veröffentlichungstag und Bekanntmachung des Hinweises auf die Patenterteilung: **16.07.1997**
(21) Anmeldenummer: 94810267.8
(22) Anmeldetag: 05.05.1994
(51) Int. Cl.: G03F 7/038, G03F 7/037, G03F 7/20, G03F 7/029, G03F 7/031

(54) **Verfahren zur Herstellung von Reliefstrukturen durch i-Linien-Bestrahlung**
Method of forming relief patterns by i-line light irradiation
Procédé de fabrication de structures en relief par irradiation dans de domaine de la bande i

(30) Priorität: 14.05.1993 CH 1484/93
(43) Veröffentlichungstag der Anmeldung: 17.11.1994
(73) Patentinhaber: OCG Microelectronic Materials Inc., West Paterson New Jersey 07424 (US)
(72) Erfinder: Hüglin, Dietmar, Dr., D-79104 Freiburg (DE); Rohde, Ottmar, Dr., D-79591 Eimeldingen (DE); Falcigno, Pasquale Alfred, D-4057 Basel (CH); Hagen, Sigurd, Dr., D-79589 Binzen (DE)
(74) Vertreter: Klunker . Schmitt-Nilson . Hirsch

(56) Entgegenhaltungen:
- EP-A- 0 119 162
- EP-A- 0 254 230
- EP-A- 0 304 136
- EP-A- 0 430 220
- EP-A- 0 580 108
- JOURNAL OF APPLIED POLYMER SCIENCE, Bd.38, Nr.3, 5. August 1989, NEW YORK , US Seiten 389 - 402, XP372018 T. OMOTE, T. YAMAOKA, K. KOSEKI 'Preparation and Properties of Soluble and Colorless Fluorine-Containing Photoreactive Polyimide Precursors'

## Beschreibung

Die vorliegende Erfindung betrifft ein Verfahren zur Herstellung photographischer Reliefabbildungen sowie Zusammensetzungen enthaltend spezifische Polyimid-Vorstufen und ausgewählte Photoinitiatoren.

Ein übliches Verfahren zur Herstellung von Polyimid-Reliefstrukturen auf elektronischen Bauteilen besteht aus der bildmässigen Belichtung von photopolymerisierbaren Polyimid-Vorstufen, dem Entfernen der unbelichteten Anteile mittels eines geeigneten Entwicklers und dem anschliessenden Tempern der erhaltenen Abbildung, wobei das Polyimid-Präpolymer in ein hitzebeständiges Polyimid überführt wird.

So werden beispielsweise in der EP-A 0 254 230 hitzebeständige Photoresistfilme beschrieben, die als wesentliche Bestandteile eine photopolymerisierbare Polyimid-Vorstufe, eine Verbindung mit einer reaktiven C-C-Doppelbindung und einen Photoinitiator enthalten.
Das US-Patent 4,548,891 beschreibt photopolymerisierbare Zusammensetzungen auf Basis von Polyamidsäureestern, deren Estergruppen eine photopolymerisierbare olefinische Doppelbindung enthalten. Die dort beschriebenen Mischungen eignen sich zur Auflösung von Strukturen bis ca 1 µm mit hoher Kantenschärfe, weisen jedoch keine ausreichend hohe Transparenz im Bereich der Quecksilber-i-Linie (ca. 360-370 nm) auf. In der Elektronik-Industrie besteht jedoch der Bedarf, Belichtungen an sogenannten "i-Linien-Steppern" durchzuführen, d.h. es werden Zusammensetzungen benötigt, die unter Bestrahlung mit UV-Licht der Wellenlänge 365 nm in einer ausreichenden Schichtdicke photopolymerisiert werden können.

In den US-Patenten 4,430,418 und 4,454,220 werden fluorhaltige Polyamidsäurester offenbart, die aus Bis(aminophenyl)perfluoralkanen bzw. Perfluoralkylidendiphthalsäuredianhydriden hergestellt werden und eine hohe Sensitivität im Bereich der i-Linie aufweisen.
In dem Aufsatz "Soluble and Optically Transparent Fluorine-Containing Photoreactive Polyimide Precursors: Spectral Sensitization by Organic Peroxide and Organic Dye Combination" in Polym. Eng. Sci. 29, 945-949 (1989) analysieren T. Omote, K. Koseki und T. Yamaoka die Absorptionseigenschaften von verschiedenen Polyamidsäureestern und stellen fest, dass fluorierte Polyamidsäureester eine wesentlich höhere Transparenz im i-Linien-Bereich besitzen als vergleichbare halogenfreie Polyimid-Vorstufen. Für die industrielle Anwendung ist jedoch der hohe Preis und die ökologische Bedenklichkeit der fluorierten Ausgangsverbindungen von Nachteil.

Die gemäss Artikel 54(3) EPÜ nachveröffentlichte EP-A-580 108 beschreibt i-Linien-Photoresists auf der Basis von Polyimid-Vorstufen als Bindemittel und Benzophenon-, Acetophenon-, Thioxanthon-, Benzil-, Benzoin- und Oximderivaten als Photoinitiatoren.

Überraschenderweise wurde nun gefunden, dass bestimmte Polyamidsäurederivate auf Basis von Oxydiphthalsäure oder auf Basis von spezifischen ortho-substituierten aromatischen Diaminen eine noch höhere Transparenz im i-Linien-Bereich aufweisen als die bekannten Polymeren auf Basis von Hexafluorisopropylidendiphthalsäuredianhydrid.

Gegenstand der vorliegenden Erfindung ist ein Verfahren zur Herstellung von Reliefabbildungen, umfassend die folgenden Schritte:
(A) Beschichten eines Substrats mit einer photopolymerisierbaren Zusammensetzung enthaltend ein Polymer (a) und einen Photoinitiator (b),
(B) bildmässiges Belichten des beschichteten Substrats mit UV-Strahlung im i-Linien-Bereich (ca. 360-370 nm),
(C) Entfernen der unbelichteten Stellen mit Hilfe eines Lösungsmittels und
(D) Tempern des belichteten und entwickelten Materials,
dadurch gekennzeichnet, dass als Polymer (a) eine Polyimid-Vorstufe enthaltend wiederkehrende Strukturelemente der Formel (I) verwendet wird, 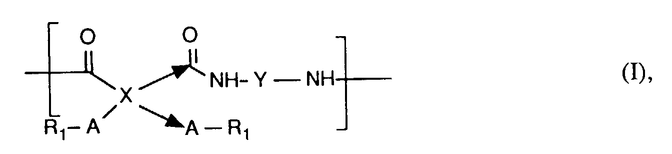 wobei → für Strukturisomere steht,
worin X den vierwertigen Rest einer aromatischen Tetracarbonsäure darstellt, Y für einen zweiwertigen aliphatischen, cycloaliphatischen oder ein- oder mehrkernigen aromatischen Rest steht, A für -COO-, -CONH- oder -COO^{⊖} HN^{⊕}R₂R₃- steht, worin R₂ und R₃ unabhängig voneinander C₁-C₆-Alkyl oder C₁-C₆-Alkenyl bedeuten, und R₁ ein Rest mit einer photopolymerisierbaren olefinischen Doppelbindung ist,
mit der Massgabe, dass mindestens 50 % aller Reste X den Rest der Oxydiphthalsäure oder mindestens 50 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy, oder C₆-C₁₄-Aryl substituiert ist.

Die durch → angedeutete Strukturisomerie in den Strukturelementen der Formel (I) kann z.B. mit Pyromellitsäure folgendermassen dargestellt werden (A = -COO-): 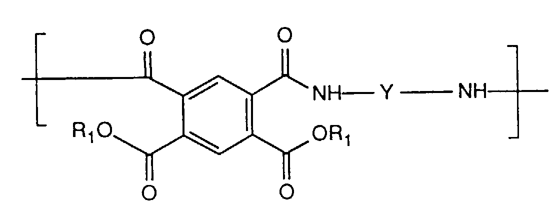 oder 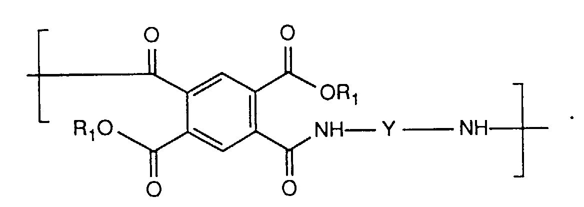 Bedeuten irgendwelche Substituenten in der Formel (I) Alkyl-, Alkenyl- oder Alkoxygruppen, so kann es sich dabei um verzweigte oder insbesondere um geradkettige Reste handeln.

Beispiele für solche Substituenten sind Methyl, Ethyl, n-Propyl, Isopropyl, n-Butyl, sek.-Butyl, tert.-Butyl, n-Pentyl, n-Hexyl, Vinyl, Prop-1-enyl, Allyl, Methallyl, But-1-enyl, But-2-enyl, Methoxy, Ethoxy, n-Propoxy, Isopropoxy, n-Butoxy, sek.-Butoxy, tert.-Butoxy, n-Pentoxy und n-Hexoxy.

Enthalten die Strukturelemente der Formel (I) Arylgruppen, so handelt es sich dabei um unsubstituierte oder um alkyl- oder alkoxysubstituierte Arylgruppen, wie beispielsweise Phenyl, Chlorphenyl, Tolyl, Xylyl, Mesityl, Isytyl, Biphenyl, Naphthyl oder Anthryl .

In einer bevorzugten Ausführungsform der Erfindung wird als Polymer (a) eine Polymid-Vorstufe enthaltend wiederkehrende Strukturelemente der Formel (I) verwendet, worin mindestens 50 %, vorzugsweise mindestens 80 % und insbesondere 100 %, aller Reste X den Rest der Oxydiphthalsäure darstellen.

Bevorzugt sind Polymere enthaltend wiederkehrende Strukturelemente der Formel (I), worin A -COO-bedeutet und R₁ für Vinyl, Allyl, Methallyl oder für einen Rest der Formel (II) steht 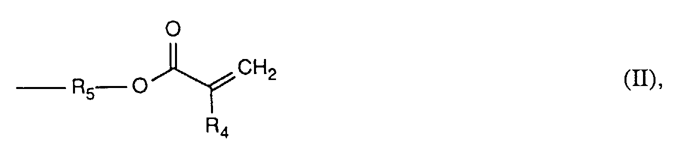 worin R₄ Wasserstoff oder Methyl bedeutet und R₅ für -CₙH₂ₙ- mit n = 2-12, -CH₂CH(OH)CH₂- oder Polyoxyalkylen mit 4-30 C-Atomen steht.

Beispiele für geeignete Reste R₅ sind Ethylen, Propylen, Trimethylen, Tetramethylen, 1,2-Butandiyl, 1,3-Butandiyl, Pentamethylen, Hexamethylen, Octamethylen, Dodecamethylen, -CH₂CH(OH)CH₂-, -(CH₂CH₂O)ₘ-CH₂CH₂-, 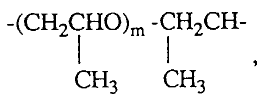 -(CH₂CH₂CH₂O)ₘ-CH₂CH₂CH₂- und -(CH₂CH₂CH₂CH₂O)ₘ-CH₂CH₂CH₂CH₂- mit m = 1-6.

R₅ ist bevorzugt Ethylen, Propylen, Trimethylen oder -CH₂CH(OH)CH₂-, und R₄ ist vorzugsweise Methyl.

Besonders bevorzugt ist R₁ ein Rest der Formel (II), worin R₄ Methyl bedeutet und R₅ für Ethylen steht.

In den Polymeren (a) enthaltend wiederkehrende Strukturelemente der Formel (I), worin mindestens 50 % aller Reste X den Rest der Oxydiphthalsäure darstellen, steht Y vorzugsweise für einen unsubstituierten oder durch einen oder mehrere C₁-C₆-Alkylgruppen oder C₁-C₆-Alkoxygruppen substituierten Rest der Formeln (III)-(V) 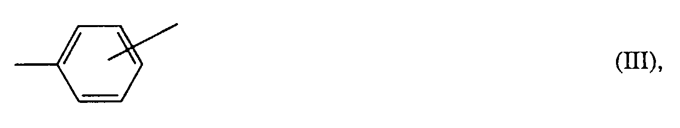 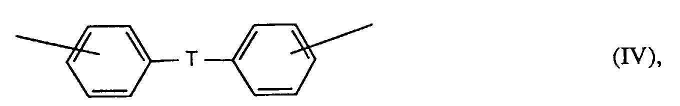 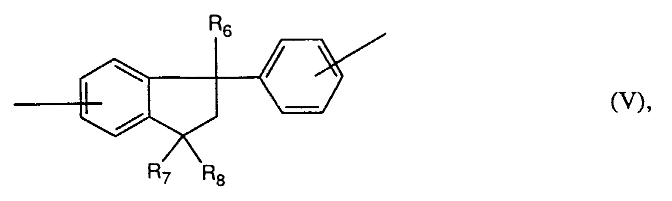 worin T für eine direkte Bindung, -CH₂-, C₂-C₁₂-Alkyliden, -C(CF₃)₂-, -NH-, -S-, -O-, -SO-, -SO₂- oder -CO- steht und R₆, R₇ und R₈ unabhängig voneinander Wasserstoff oder C₁-C₆-Alkyl bedeuten.

Besonders bevorzugt sind Polymere (a) enthaltend wiederkehrende Strukturelemente der Formel (I), worin mindestens 50 % aller Reste X den Rest der Oxydiphthalsäure darstellen, worin Y für einen Rest der Formeln (VI)-(VIII) steht 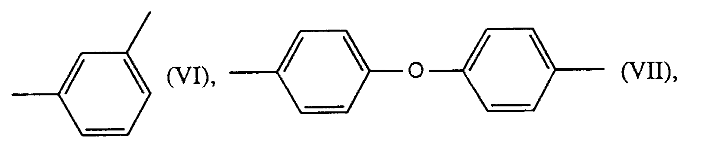 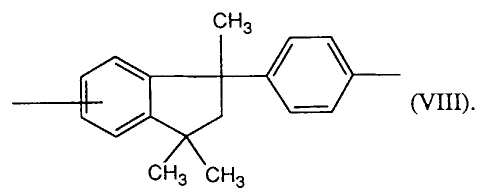 In einer weiteren Ausführungsform der Erfindung wird als Polymer (a) eine Polyimid-Vorstufe enthaltend wiederkehrende Strukturelemente der Formel (I) verwendet, worin mindestens 50 %, vorzugsweise mindestens 80 % und insbesondere 100 %, aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist.

In den Polymeren (a) enthaltend wiederkehrende Strukturelemente der Formel (I), worin mindestens 50 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist, steht Y vorzugsweise für einen Rest der Formeln (IX), (X) oder (XI) 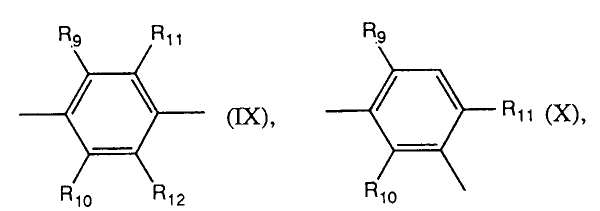 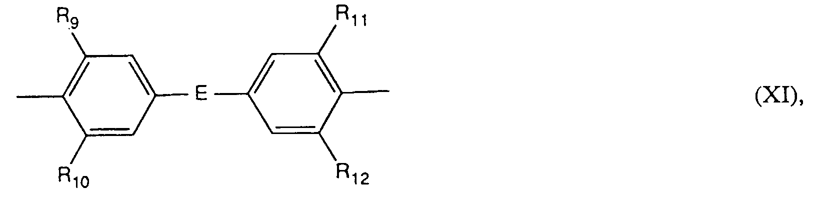 worin R₉, R₁₀, R₁₁ und R₁₂ unabhängig voneinander C₁-C₆-Alkyl bedeuten und E für eine direkte Bindung, -CH₂-, C₂-C₁₂-Alkyliden, -C(CF₃)₂-, -NH-, -S-, -O-, -SO-, -SO₂- oder -CO- steht.

Besonders bevorzugt sind Polymere (a) enthaltend wiederkehrende Strukturelemente der Formel (I), worin mindestens 50 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist, worin Y für 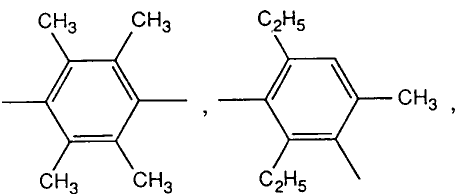 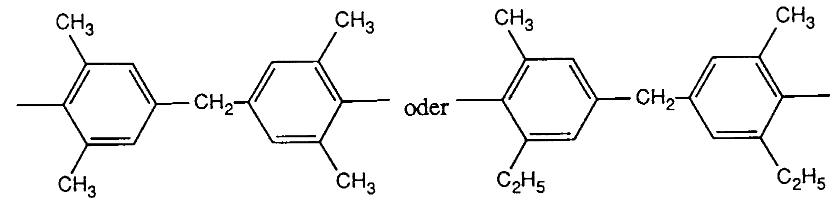 steht.

In den Polymeren (a) enthaltend wiederkehrende Strukturelemente der Formel (I), worin mindestens 50 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist, steht X bevorzugt für den Rest der Pyromellitsäure, der 3,3,,4,4'-Biphenyltetracarbonsäure, der Oxydiphthalsäure, der 3,3',4,4'-Benzophenontetracarbonsäure oder der Hexafluorisopropylidendiphthalsäure.

Die in dem erfindungsgemässen Verfahren zu verwendenden Polymeren (a) können nach verschiedenen bekannten Methoden hergestellt werden, beispielsweise nach den im US-Patent 4,548,891 oder in der EP-A 0 254 230 beschriebenen Verfahren. Geeignete Ausgangsverbindungen für die Synthese der Polymeren (a) sind zum Beispiel die Tetracarbonsäuredianhydride der Formel (XII) 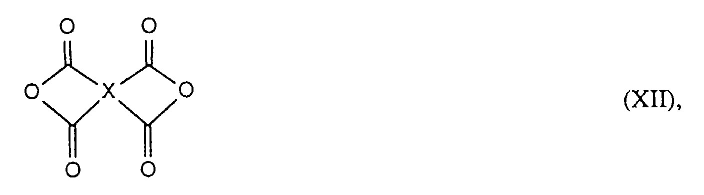 worin X die oben angegebene Bedeutung hat.

Zur Herstellung der Polymeren (a) enthaltend wiederkehrende Strukturelemente der Formel (I), worin A -COO- bedeutet, eignet sich insbesondere der folgende Syntheseweg: Zunächst wird ein Dianhydrid der Formel (XII) mit einer Hydroxyverbindung der Formel R₁-OH, worin R₁ die oben angegebene Bedeutung hat, zur Diesterdicarbonsäure der Formel (XIII) umgesetzt 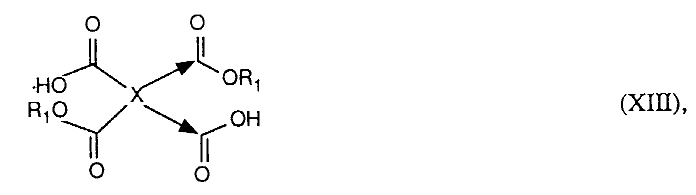 wobei → für Strukturisomere steht.
Die Diesterdicarbonsäure der Formel (XIII) wird dann vorzugsweise in ein aktiviertes Derivat überführt, welches anschliessend mit einem Diamin der Formel H₂N-Y-NH₂, worin Y die oben angegebene Bedeutung hat, zum Polyamidsäureester enthaltend wiederkehrende Strukturelemente der Formel (I), worin A -COO- bedeutet, polykondensiert wird. Die Aktivierung der Diesterdicarbonsäure der Formel (XIII) erfolgt üblicherweise über das Dichlorid. Diese Reaktionsfolge ist ausführlich im US-Patent 4,040,831 beschrieben. Des weiteren kann auch der von F. Hayano und H. Komoto in J. Polym. Sci. A-1, 1263 (1972) beschriebene Weg über spezielle aktivierte Amide, insbesondere Imidazolide, eingeschlagen werden.
Die Diesterdicarbonsäure der Formel (XIII) kann auch mittels starker Kondensationsmittel direkt mit dem Diamin der Formel H₂N-Y-NH₂ zum Polyamidsäureester kondensiert werden. Als Kondensationsmittel eignen sich gemäss EP-A 0 254 230 insbesondere Dicyclohexylcarbodiimid oder auch die von M. Ueda et al. in Macromolecules 21, 19 (1988) oder von F.M. Haulihan et al. in Macromolecules 22, 4477 (1989) beschriebenen Phosphonate.

Die Polyamidsäureester enthaltend wiederkehrende Strukturelemente der Formel (I), worin A -COO- bedeutet, können auch nach dem im US-Patent 4,551,522 beschriebenen Verfahren hergestellt werden, wobei das Dianhydrid der Formel (XII) zunächst mit dem Diamin der Formel H₂N-Y-NH₂ polykondensiert und die so erhaltene Poly(amidsäure) mit Dicyclohexylcarbodiimid oder Trifluoressigsäureanhydrid zum Poly(isoimid) umgesetzt wird. Die anschliessende Addition der Hydroxyverbindung R₁-OH führt zum Polyamidsäureester.

Die Polymeren (a) enthaltend wiederkehrende Strukturelemente der Formel (I), worin A für -COO^{⊖}HN^{⊕}R₂R₃- steht und R₂ und R₃ die oben angegebene Bedeutung haben, sind ebenfalls, z.B. nach dem in der EP-A 245 230 beschriebenen Verfahren, aus den Tetracarbonsäuredianhydriden der Formel (XII) zugänglich. Dabei wird zweckmässig, wie oben angegeben, zunächst eine Poly(amidsäure) aus einem Anhydrid der Formel (XII) und einem Diamin der Formel H₂N-Y-NH₂ hergestellt und anschliessend mit einem Amin der Formel R₁NR₂R₃ umgesetzt, worin R₁, R₂ und R₃ die oben angegebene Bedeutung haben.

Geeignete Dianhydride der Formel (XII) sind beispielsweise Pyromellitsäuredianhydrid, 3,3',4,4'-Biphenyltetracarbonsäuredianhydrid, 3,3',4,4'-Diphenylsulfidtetracarbonsäuredianhydrid, 3,3',4,4'-Diphenylsulfontetracarbonsäuredianhydrid, 3,3',4,4'-Benzophenontetracarbonsäuredianhydrid, 3,3',4,4'-Diphenylmethantetracarbonsäuredianhydrid, 2,2',3,3'-Diphenylmethantetracarbonsäuredianhydrid, 2,3,3',4'-Biphenyltetracarbonsäuredianhydrid, 2,3,3',4'-Benzophenontetracarbonsäuredianhydrid, 2,3,6,7-Naphthalintetracarbonsäuredianhydrid, 1,4,5,7-Naphthalintetracarbonsäuredianhydrid, 1,2,5,6-Naphthalintetracarbonsäuredianhydrid, 2,2-Bis(3,4-dicarboxyphenyl)propandianhydrid, 2,2-Bis(2,3,-dicarboxyphenyl)propandianhydrid, 2,2-Bis(3,4-dicarboxyphenyl)hexafluorpropandianhydrid, 1,3-Diphenylhexafluorpropan-3,3,4,4-tetracarbonsäuredianhydrid, 1,4,5,6-Naphthalintetracarbonsäuredianhydrid, 2,2',3,3'-Diphenyltetracarbonsäuredianhydrid, 3,4,9,10-Perylentetracarbonsäuredianhydrid, 1,2,4,5-Naphthalintetracarbonsäuredianhydrid, 1,4,5,8-Naphthalintetracarbonsäuredianhydrid, 1,8,9,10-Phenanthrentetracarbonsäuredianhydrid, 1,1-Bis(2,3-dicarboxyphenyl)ethandianhydrid, 1,1-Bis(3,4-dicarboxyphenyl)ethandianhydrid, 1,2,3,4-Benzoltetracarbonsäuredianhydrid, sowie deren C₁-C₆-Alkyl-und C₁-C₆-Alkoxyderivate.
Diese Verbindungen sind bekannt und zum Teil im Handel erhältlich.
Es können auch Mischungen der oben genannten Dianhydride eingesetzt werden.

Als Ausgangsverbindungen H₂N-Y-NH₂ können aliphatische, cycloaliphatische und aromatische Diamine eingesetzt werden.

Beispiele für aliphatische Diamine sind 1,2-Diaminoethan, 1,2-Diaminopropan, 1,3-Diaminopropan, 1,4-Diaminobutan und 1,6-Diaminohexan.

Geeignete cycloaliphatische Diamine sind zum Beispiel 1,2- oder 1,3-Diaminocyclopentan, 1,2-, 1,3- oder 1,4-Diaminocyclohexan, 1,2-, 1,3- oder 1 ,4-Bis(aminomethyl)cyclohexan, Bis-(4-aminocyclohexyl)-methan, Bis-(3-aminocyclohexyl)-methan, 4,4'-Diamino-3,3'-dimethylcyclohexylmethan und Isophorondiamin.

Als geeignete aromatische Diamine seien beispielsweise genannt: m- und p-Phenylendiamin, Diaminotoluol, 4,4'- und 3,3'-Diaminobiphenyl, 4,4'- und 3,3'-Diaminodiphenylether, 4,4'- und 3,3'-Diaminodiphenylmethan, 4,4'- und 3,3'-Diaminodiphenylsulfon, 4,4'- und 3,3'-Diaminodiphenylsulfid, 4,4'- und 3,3'-Diaminobenzophenon, 3,3'-Dimethyl-4,4'-diaminobiphenyl, 2,2'-Dimethyl-4,4'-diaminobiphenyl, 3,3'-Dimethoxy-4,4'-diaminobiphenyl, 2,2-Bis(4-aminophenyl)propan, 2,2-Bis(4-aminophenyl)hexafluorpropan, 2,2-Bis(3-hydroxy-4-aminophenyl)propan, 2,2-Bis(3-hydroxy-4-aminophenyl)hexafluorpropan, 4,4'-Diaminoparaterphenyl, 4,4'-Bis(4-aminophenoxy)biphenyl, Bis[4-(4-aminophenoxy)phenyl]sulfon, Bis[4-(3-aminophenoxy)phenyl]sulfon, Bis[4-(2-aminophenoxy)phenyl]sulfon, 1,4-Bis(4-aminophenoxy)benzol, 9,10-Bis(4-aminophenyl)anthracen, 3,3'-Dimethyl-4,4'-diaminodiphenylsulfon, 1,3-Bis(4-aminophenoxy)benzol, 1,3-Bis(3-aminophenoxy)benzol, 1,3-Bis(4-aminophenyl)benzol, Bis[4-(4-aminophenoxy)phenylether, 3,3'-Diethyl-4,4'-diaminodiphenylmethan, 3,3'-Dimethyl-4,4'-diaminodiphenylmethan, 4,4'-Diaminooctafluorbiphenyl, 2,2-Bis[4-(4-aminophenoxy)phenyl]propan, 2,2-Bis[4-(4-aminophenoxy)phenyl]hexafluorpropan, 2,2-Bis(4-aminophenyl)hexafluorpropan, 9,9-Bis(4-aminophenyl)-10-hydroanthracen, 3,3',4,4'-Tetraaminobiphenyl, 3,3',4,4'-Tetraaminodiphenylether, 1,4-Diaminoanthrachinon, 1,5-Diaminoanthrachinon, Bis[4-(4-aminophenoxy)phenyl]sulfon, Bis[4-(3-aminophenoxy)phenyl]sulfon, Bis[4-(2-aminophenoxy)phenyl]sulfon, 3,3-Dihydroxy-4,4'-diaminobiphenyl, 9,9'-Bis(4-aminophenyl)fluoren, 4,4'-Dimethyl-3,3'-diaminodiphenylsulfon, 3,3',5,5'-Tetramethyl-4,4'-diaminodiphenylmethan, 2,4- und 2,5-Diaminocumol, 2,5-Dimethyl-p-phenylendiamin, Acetoguanamin, 2,3,5,6-Tetramethyl-p-phenylendiamin, 2,4,6-Trimethyl-m-phenylendiamin, Bis(3-aminopropyl)tetramethyldisiloxan, 2,7-Diaminofluoren, 2,5-Diaminopyridin, 1,2-Bis(4-aminophenyl)ethan, Diaminobenzanilid, Ester der Diaminobenzoesäure, 1,5-Diaminonaphthalin, Diaminobenzotrifluorid, Diaminoanthrachinon, 1,3-Bis(4-aminophenyl)hexafluorpropan, 1,4-Bis(4-aminophenyl)octafluorbutan, 1,5-Bis(4-aminophenyl)decafluorpentan, 1,7-Bis(4-aminophenyl)tetradecafluorheptan, 2,2-Bis[4-(3-aminophenoxy)phenyl]hexafluorpropan, 2,2-Bis[4-(2-aminophenoxy)phenyl]hexafluorpropan, 2,2-Bis[4-(4-aminophenoxy)-3,5-dimethylphenyl]hexafluorpropan, 2,2-Bis[4-(4-aminophenoxy)-3,5-bis(trifluormethyl)phenyl]hexafluorpropan, p-Bis(4-amino-2-trifluormethylphenoxy)benzol,4,4'-Bis(4-amino-2-trifluormethylphenoxy)biphenyl,4,4'-Bis(4-amino-3-trifluormethylphenoxy)biphenyl, 4,4'-Bis(4-amino-2-trifluormethylphenoxy)diphenylsulfon, 4,4'-Bis(3-amino-5-trifluormethylphenoxy)diphenylsulfon, 2,2-Bis[4-(4-amino-3-trifluormethylphenoxy)phenyl]hexafluorpropan, 3,3',5,5,-Tetramethyl-4,4'-diaminobiphenyl, 3,3'-Dimethoxy-4,4'-diaminobiphenyl, 2,2',5,5',6,6'-Hexafluortolidin und 4,4'''-Diaminoquaterphenyl.

Beispiele für geeignete Hydroxyverbindungen der Formel R₁-OH sind Vinylalkohol, Allylalkohol, Methallylalkohol, 2-Hydroxyethylacrylat, 2-Hydroxyethylmethacrylat, 3-Hydroxypropylacrylat, 3-Hydroxypropylmethacrylat, 2-Hydroxypropylacrylat, 2-Hydroxypropylmethacrylat, 4-Hydroxybutylacrylat, 4-Hydroxybutylmethacrylat, Diethylenglykolmonoacrylat, Diethylenglykolmonomethacrylat, Triethylenglykolmonoacrylat, Triethylenglykolmonomethacrylat, Dipropylenglykolmonoacrylat, Dipropylenglykolmonomethacrylat, 2,3 -Dihydroxypropylacrylat und -methacrylat.

Die photopolymerisierbare Zusammensetzung, die im Schritt (A) des erfindungsgemässen Verfahrens eingesetzt wird, enthält neben dem Polymer (a) mindestens einen Photoinitiator (b) und gegebenenfalls (c) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

Als Komponente (b) können im Prinzip alle dem Fachmann bekannten Photoinitiatoren eingesetzt werden, die eine ausreichend hohe Empfindlichkeit im Bereich der Quecksilber-i-Linie aufweisen.
Beispiele für solche Photoinitiatoren werden z.B. von K.K. Dietliker in "Chemistry and Technology of UV & EB Formulation for Coatings, Inks and Paints", Volume 3: "Photoinitiators for Free Radical and Cationic Polymerisation" angegeben. Geeignet sind beispielsweise Benzoinether, wie z.B. Benzoinmethylether, Ketale, wie Diethoxyacetophenon oder Benzildimethylketal, Hexaarylbisimidazole, Chinone, wie z.B. 2-tert.-Butylanthrachinon, oder Thioxanthone, die vorzugsweise in Kombination mit Amin-Coinitiatoren eingesetzt werden, wie beispielsweise Thioxanthon, 2-Isopropylthioxanthon oder 2-Chlorthioxanthon.

Vorzugsweise werden als Photoinitiatoren (b) die beispielsweise aus der EP-A 0 119 162 bekannten Titanocene eingesetzt.

Die Mitverwendung der Komponente (c) ist erfindungsgemäss nicht unbedingt erforderlich, jedoch bevorzugt, da damit eine wesentliche Erhöhung der Lichtempfindlichkeit der photopolymerisierbaren Zusammensetzung (Verkürzung der Belichtungszeiten) erzielt werden kann. Der Photoinitiator (b) ist vorzugsweise in einer Menge von 0,1-20 Gew.-%, insbesondere 0,5-10 Gew.-%, zugegen, bezogen auf die Komponente (a) bzw. die Summe der Komponenten (a) und (c). Die Zusammensetzung enthält die Komponente (a) vorzugsweise in einer Menge von 50-97,5 Gew.-%, besonders 70-95 Gew.-%, und die Komponente (c) vorzugsweise in einer Menge von 2,5-50 Gew.-%, besonders 5-30 Gew.-%. Besonders bevorzugt sind Zusammensetzungen, die 85-90 Gew.-% der Komponente (a) und 10-15 Gew.-% der Komponente (c) enthalten.

Als Komponente (c) kommen beispielsweise Ether und vor allem Ester und Teilester von Acrylsäure oder Methacrylsäure und aromatischen und insbesondere aliphatischen Polyolen mit insbesondere 2-30 C-Atomen oder cycloaliphatischen Polyolen mit bevorzugt 5 oder 6 Ringkohlenstoffatomen in Betracht. Diese Polyole können auch mit Epoxiden, wie Ethylenoxid oder Propylenoxid, modifiziert sein. Ferner sind auch die Ester und Teilester von Polyoxyalkylenglykolen geeignet.
Beispiele für geeignete Komponenten (c) sind Ethylenglykoldiacrylat, Ethylenglykoldimethacrylat, Diethylenglykoldiacrylat, Diethylenglykoldimethacrylat, Triethylenglykoldiacrylat, Triethylenglykoldimethacrylat, Tetraethylenglykoldiacrylat, Tetraethylenglykoldimethacrylat, Polyethylenglykoldi(meth)acrylate mit einem mittleren Molekulargewicht im Bereich von 200-2000, Trimethylolpropanethoxylattri(meth)acrylat, Trimethylolpropanpolyethoxylattri(meth)acrylate mit einem mittleren Molekulargewicht im Bereich von 500-1500, Pentaerythrittri(meth)acrylat, Pentaerythritdi(meth)acrylat, Pentaerythrittetra(meth)acrylat, Dipentaerythritdi(meth)acrylat, Dipentaerythrittri(meth)acrylat, Dipentaerythrittetra(meth)acrylat, Dipentaerythrithexa(meth)acrylat, Tripentaerythritocta(meth)acrylat, 1,3-Butandioldi(meth)acrylat, Sorbittri(meth)acrylat, Sorbittetra(meth)acrylat, Sorbitpenta(meth)acrylat, Sorbithexa(meth)acrylat, Oligoester(meth)acrylate, Glycerindi(meth)acrylat, Glycerintri(meth)acrylat, 1,4-Cyclohexandi(meth)acrylat, Bis(meth)acrylate von Polyethylenglykolen mit einem mittleren Molekulargewicht im Bereich von 500-1500, Ethylenglykoldiallylether, Trimethylolpropantriallylether, Pentaerythrittriallylether, Bernsteinsäure- und Adipinsäurediallylether oder Gemische der genannten Verbindungen.

Die photoempfindliche Zusammensetzung kann weitere übliche Zusatzstoffe enthalten, z.B. Stabilisatoren, insbesondere Inhibitoren für die thermische Polymerisation, wie Thiodiphenylamin und Alkylphenole, z.B. 4-tert.-Butylphenol, 2,5-Di-tert.-butylhydrochinon oder 2,6-Di-tert.-butyl-4-methylphenol. Weitere geeignete Initiatoren und Sensibilisatoren sind z.B. aromatische Ketone wie Tetramethyldiaminobenzophenon, Benzophenon, Michlers Keton und andere aromatische Ketone, z.B. die im US-Patent 3,552,973 erwähnten Verbindungen, Benzoin, Benzoinether wie beispielsweise Benzoinmethylether, Methylbenzoin, Ethylbenzoin, p-Maleinimidobenzolsulfonsäureazid, Thioxanthonderivate, wie Thioxanthon, 2-Chlorthioxanthon oder 2-Isopropylthioxanthon oder Bisazide wie z.B. 2,6-(4'-Azidobenzyliden-4)-methylcyclohexan-1-on.
Weitere Zusätze sind Lösungsmittel, die allein oder in Kombinationen verwendet werden können, wie N-Methylpyrrolidon, γ-Butyrolacton, Ethylenglykolmonomethylether, Dimethylformamid, Dimethylacetamid und Hexamethylphosphorsäuretriamid; Pigmente, Farbstoffe, Füllstoffe, Haftmittel, Netzmittel und Weichmacher, sowie Farbstoffe, die durch ihre Eigenabsorption die spektrale Empfindlichkeit der Mischungen beeinflussen können.

Die Herstellung der photoempfindliche Zusammensetzungen erfolgt durch Vermischen der Komponenten in hierfür üblichen Einrichtungen.
Die photoempfindlichen Zusammensetzungen eignen sich hervorragend als Beschichtungsmittel für Substrate aller Art, z.B. Keramik, Metalle, wie Kupfer oder Aluminium, Halbmetalle und Halbleitermaterialien, wie Silicium, Germanium, GaAs, SiO₂ und Si₃N₄-Schichten, bei denen durch Photopolymerisation eine Schutzschicht oder eine photographische Abbildung aufgebracht werden soll.
Die Herstellung der beschichteten Substrate kann zum Beispiel erfolgen, indem man eine Lösung oder Suspension der Zusammensetzung herstellt. Die Wahl des Lösungsmittels und die Konzentration richtet sich hauptsächlich nach der Art der Zusammensetzung und nach dem Beschichtungsverfahren. Die Lösung wird mittels bekannten Beschichtungsverfahren auf ein Substrat gleichförmig aufgebracht, z.B. durch Schleudern, Tauchen, Rakelbeschichtung, Vorhanggiessverfahren, Aufpinseln, Sprühen, speziell durch elektrostatisches Sprühen und Reverse-Rollbeschichtung. Es ist auch möglich, die lichtempfindliche Schicht auf einen temporären, flexiblen Träger zu bringen, und dann durch Schichtübertragung via Laminierung das endgültige Substrat, z.B. eine kupferkaschierte Leiterplatte, zu beschichten.
Die Auftragsmenge (Schichtdicke) und Art des Substrates (Schichtträger) sind abhängig vom gewünschten Applikationsgebiet. Besonders vorteilhaft ist es, dass die photoempfindlichen Zusammensetzungen in weiter variablen Schichtdicken eingesetzt werden können. Dieser Schichtdickenbereich umfasst Werte von ca. 0,5 µm bis mehr als 100 µm.
Die Photopolymerisation von (Meth)acrylaten und ähnlichen olefinisch ungesättigten Verbindungen wird bekanntlich durch Luftsauerstoff gehemmt, besonders in dünnen Schichten. Dieser Effekt lässt sich mit bekannten üblichen Methoden, wie z.B. Aufbringen einer temporären Deckschicht aus Polyvinylalkohol oder durch Vorbelichten oder Vorkonditionieren unter Inertgas, vermindern.
Nach dem Beschichten wird das Lösungsmittel in der Regel durch Trocknen entfernt, und es resultiert eine Schicht der photoempfindlichen Zusammensetzung auf dem Träger.
Nach der in üblicher Weise erfolgten bildmässigen Belichtung des Materials mit UV-Strahlung im Bereich der Quecksilber-i-Linie (ca. 360-370 nm) werden die unbelichteten Stellen des Photolackes durch Herauslösen in einem Entwickler entfernt. Geeignete Entwickler sind z.B. polare Lösungsmittel wie N-Methylpyrrolidon, N-Acetylpyrrolidon, γ-Butyrolacton, Ethylenglykolmonomethylether, Dimethylformamid, Dimethylacetamid, Dimethylsulfoxid und Cyclohexanon, gegebenfalls in Kombination mit weiteren Lösungsmitteln wie Toluol, Xylol, Ethanol, Methanol, Isopropanol, n-Butylacetat oder Aceton.

Nach der Entwicklung werden die beschichteten Materialien zu bei hohen Temperaturen beständigen Reliefstrukturen getempert, vorzugsweise bei Temperaturen zwischen 300 °C und 400 °C, wobei die Polyimid-Vorstufen in hitzebeständige Polyimide überführt und flüchtige Anteile entfernt werden.

Das erfindungsgemässen Verfahren zeichnet sich durch eine hohe Empfindlichkeit bei der i-Linien-Belichtung aus und liefert hitze- und chemikalienbeständige Reliefstrukturen mit hoher Kantenschärfe.

Mögliche Einsatzgebiete des erfindungsgemässen Verfahrens sind die Verwendung als Photoresists für die Elektronik (Galvanoresist, Ätzresist, Lötstoppresist), die Herstellung von Druckplatten, wie Offsetdruckplatten oder Siebdruckformen, der Einsatz beim Formteilätzen und insbesondere die Herstellung von Polyimid-Schutzlacken und dielektrischen Schichten in der Elektronik, insbesondere in der Mikroelektronik.

Die Zusammensetzungen enthaltend ein Polymer (a) gemäss der oben angegebenen Definition und einen Titanocen-Photoinitiator sind neu und bilden einen weiteren Erfindungsgegenstand.

Gegenstand der vorliegenden Erfindung ist somit eine Zusammensetzung enthaltend
(a) ein Polymer enthaltend wiederkehrende Strukturelemente der Formel (I) 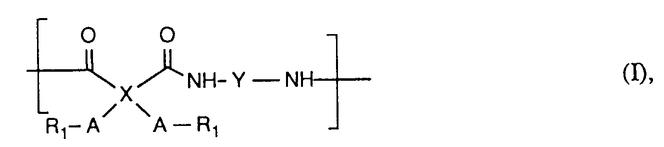 worin X den vierwertigen Rest einer aromatischen Tetracarbonsäure darstellt, Y für einen zweiwertigen aliphatischen, cycloaliphatischen oder ein- oder mehrkernigen aromatischen Rest steht, A für -COO-, -CONH- oder -COO^{⊖}HN^{⊕}R₂R₃-steht, worin R₂ und R₃ unabhängig voneinander C₁-C₆-Alkyl oder C₁-C₆-Alkenyl bedeuten, und R₁ ein Rest mit einer photopolymerisierbaren olefinischen Doppelbindung ist,
   mit der Massgabe, dass mindestens 50 % aller Reste X den Rest der Oxydiphthalsäure oder mindestens 50 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist, und
(b) ein Titanocen der Formel (XIV) 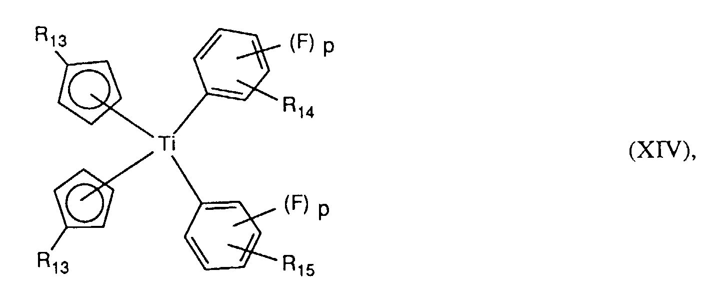 worin beide Reste R₁₃ unabhängig voneinander Wasserstoff oder C₁-C₆-Alkyl bedeuten, R₁₄ und R₁₅ für C₁-C₆-Alkyl, C₆-C₁₄-Aryl oder einen heterocyclischen fünf- oder sechsgliedrigen aliphatischen oder aromatischen Ring stehen und p eine Zahl von 2 bis 5 ist, mit der Massgabe, dass jeweils zwei Fluoratome die ortho-Positionen der beiden Phenylringe besetzen.

Bei den Resten R₁₃ handelt es sich bevorzugt um gleiche Substituenten. Insbesondere sind beide R₁₃ Wasserstoff oder Methyl.

Besonders bevorzugt wird in den erfindungsgemässen Zusammensetzungen als Komponente (b) ein Titanocen der Formeln (XV)-(XVIII) eingesetzt

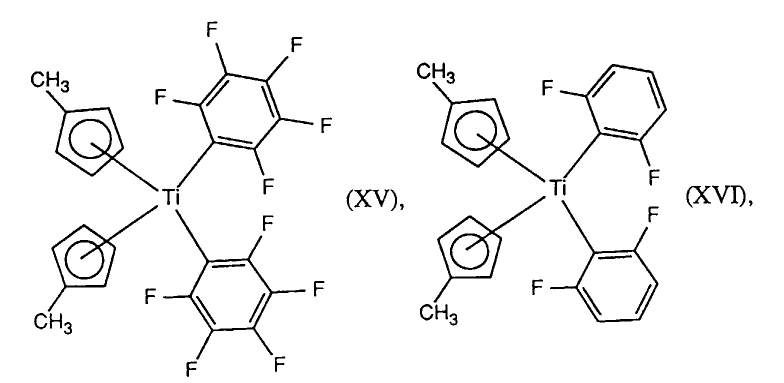

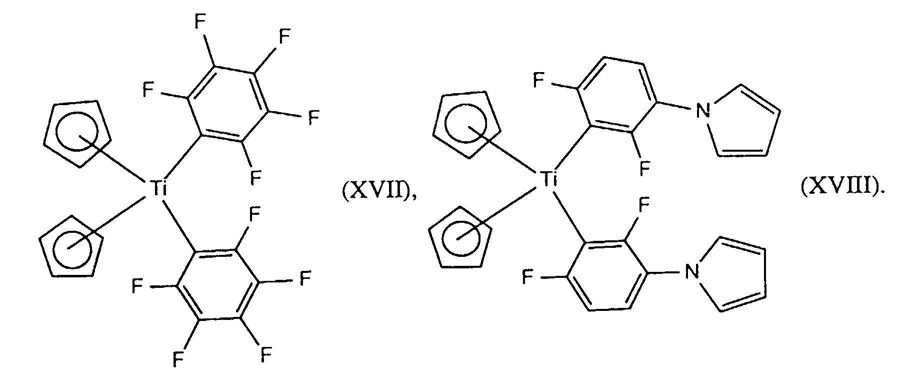

Weitere bevorzugte Photoinitiatoren, die in dem erfindungsgemässen Verfahren eingesetzt werden können, sind die beispielsweise im US-Patent 5 019 482 offenbarten Oximester. Überraschenderweise wurde gefunden, dass bei Verwendung einiger spezifischer Triketonoximester auch beim Erwärmen auf hohe Temperaturen keine Dunkelfärbung der Mischung auftritt.

Gegenstand der Erfindung ist somit weiterhin eine Zusammensetzung enthaltend
(a) ein Polymer enthaltend wiederkehrende Strukturelemente der Formel (I) gemäss Anspruch 1,
(b) ein Triketonoximester der Formel (XX) 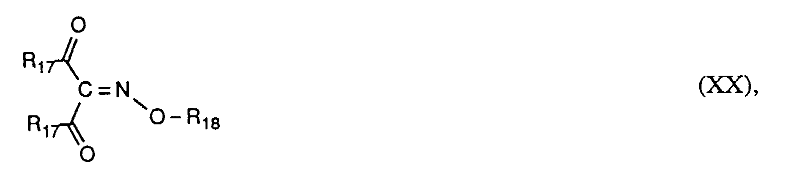 worin die Reste R₁₇ unabhängig voneinander für p-Tolyl, p-Alkoxyphenyl oder Mesityl stehen und R₁₈ C₁-C₆-Alkylcarbonyl, C₁-C₆-Alkoxycarbonyl, C₆-C₁₄-Arylcarbonyl oder C₆-C₁₄-Aryloxycarbonyl bedeutet, und
(c) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

Die Triketonoximester der Formel (XX) können nach bekannten Methoden hergestellt werden, z.B. durch Überführung der entsprechenden Triketone in Oxime (z.B. gemäss "Organic Synthesis, Vol. 40, Seite 21-23) und anschliessende Umsetzung mit Säurechloriden oder Chlorkohlensäureestern.

In bevorzugten Verbindungen der Formel (XX) steht R₁₇ für p-Tolyl und R₁₈ für C₆-C₁₄-Arylcarbonyl.

Besonders bevorzugt ist die Verbindung der Formel (XXa)

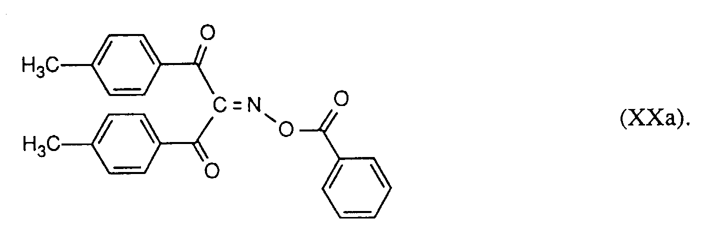

Im allgemeinen enthalten die erfindungsgemässen Zusammensetzungen 1-10 Gew.-% der Komponente (b) und 1-20 Gew.-% der Komponente (c), bezogen auf die Komponente (a).

Einen weiteren Erfindungsgegenstand bildet eine Zusammensetzung enthaltend
(a) ein Polymer enthaltend wiederkehrende Strukturelemente der Formel (I),
(b) ein Triketonoximester der Formel (XX),
(c) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren, und zusätzlich
(d) ein aromatisches Amin der Formel (XXI) 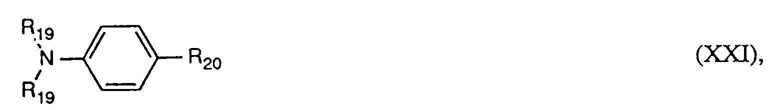 bedeutet, worin die beiden R₁₉ unabhängig voneinander für C₁-C₃-Alkyl oder C₁-C₃-Hydroxyalkyl stehen oder zusammen mit dem N-Atom eine Morpholingruppe bilden und R₂₀ eine C₁-C₃-Alkylgruppe, C₂-C₅-Alkylcarbonylgruppe oder C₇-C₁₀-Arylcarbonylgruppe darstellt.

Geeignete aromatische Amine der Formel (XXI) sind beispielsweise 4-Dimethylaminoacetophenon, 4-Morpholinoacetophenon, 4-Dimethylaminobenzophenon, 4-Morpholinobenzophenon, N-Phenyldiethanolamin, N-p-Tolyldiethylamin und N-p-Tolyldiethanolamin.

Die aromatischen Amine der Formel (XXI) werden im allgemeinen in einer Menge von 0,5-5 Gew.-%, bezogen auf die Komponente (a), eingesetzt.

Falls eine Belichtung bei anderen Wellenlängen als der i-Linie ebenfalls gewünscht ist, so ist es möglich, durch Zugabe von weiteren Photosensibilisatoren zusätzlich Photoempfindlichkeit in anderen spektralen Bereichen zu erzeugen, z.B. bei der Wellenänge der g-Linie (436 nm).

Einen weiteren Erfindungsgegenstand bildet daher eine Zusammensetzung enthaltend
(a) ein Polymer enthaltend wiederkehrende Strukturelemente der Formel (I),
(b) ein Triketonoximester der Formel (XX),
(c) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren, und zusätzlich
(d) ein aromatisches Amin der Formel (XXI) und
(e) ein Cumarin der Formel (XXII) 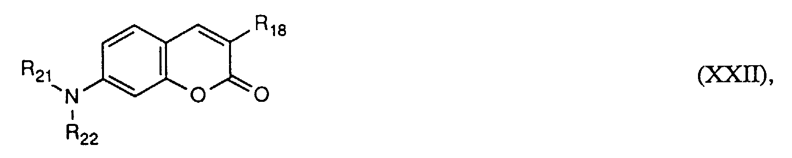 steht, worin R₂₁ und R₂₂ unabhängig voneinander C₁-C₆-Alkylgruppen sind und R₁₈ C₁-C₆-Alkylcarbonyl, C₁-C₆-Alkoxycarbonyl, C₆-C₁₄-Arylcarbonyl oder C₆-C₁₄-Aryloxycarbonyl bedeutet.

Vorzugsweise werden als Komponente (e) die im US-Patent 5 019 482 offenbarten Cumarine eingesetzt. Besonders bevorzugt ist das Cumarin der Formel (XXIIa)

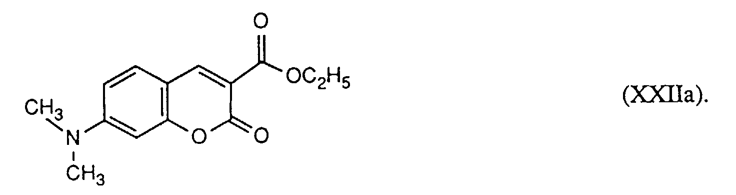

Die Cumarine der Formel (XXII) werden im allgemeinen in einer Menge von 0,1-5 Gew.-%, bezogen auf die Komponente (a), eingesetzt.

Die Photosensitivität der erfindungsgemässen Zusammensetzungen kann weiterhin durch den Zusatz von aromatischen heterozyklischen Verbindungen, die mindestens eine Mercaptogruppe enthalten, gesteigert werden. Beispiele für derartige Verbindungen sind 2-Mercaptobenzimidazol, 2-Mercaptobenzothiazol, 1-Phenyl-5-mercapto-1H-tetrazol, 2-Mercapto-4-phenylthiazol, 2-Amino-5-mercapto-4-phenylthiazol, 2-Amino-4-mercapto-1,3,4-thiazol, 2-Mercaptoimidazol, 2-Mercapto-5-methyl-1,3,4-thiazol, 5-Mercapto-1-methyl-1H-tetrazol, 2,4,6-Trimercapto-s-triazin, 2-Dibutylamino-4,6-dimercapto-s-triazin, 2,5-Dimercapto-1,3,4-thiadiazol, 5-Mercapto-1,3,4-thiadiazol, 1-Ethyl-5-mercapto-1,2,3,4-tetrazol, 2-Mercapto-6-nitrothiazol, 2-Mercaptobenzoxazol, 4-Phenyl-2-mercaptothiazol, Mercaptopyridin, 2-Mercaptochinolin, 1-Methyl-2-mercaptoimidazol und 2-Mercapto-β-naphthothiazol.

Solche Mercaptoverbindungen werden im allgemeinen in einer Menge von 0,5-5 Gew.-%, bezogen auf die Komponente (a), eingesetzt.

Vorzugsweise wird 2-Mercaptobenzothiazol verwendet.

Eine weitere bevorzugte Ausführungsform der Erfindung betrifft eine Zusammensetzung enthaltend
(a) ein Polymer enthaltend wiederkehrende Strukturelemente der Formel (I) gemäss Anspruch 1,
(b) ein Cumarin der Formel (XXIII) 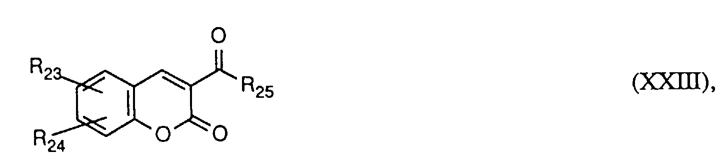 worin R₂₃ und R₂₄ unabhängig voneinander Wasserstoff oder C₁-C₆-Alkoxy bedeuten und R₂₅ für C₆-C₁₄-Aryl oder einen Rest der Formel (XXIV) steht 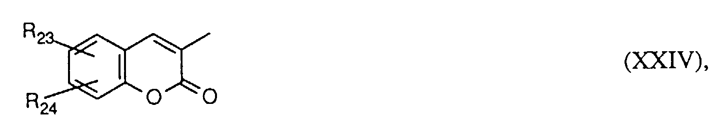 worin R₂₃ und R₂₄ die gleiche Bedeutung wie in Formel (XXIII) haben, und
(c) eine Aminosäure der Formel (XXV) 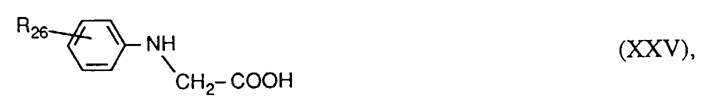 worin R₂₆ für Wasserstoff, Methyl, Ethyl, i-Propyl, t-Butyl, Phenyl, Methoxy, Ethoxy, Hydroxy, Hydroxymethyl, Dimethylamino, Diethylamino, Acetyl, Propionyl, Acetyloxy, Propionyloxy, -NHCONH₂ oder -NHCOOCH₃ steht, und gegebenenfalls
(d) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

Die Cumarine der Formel (XXIII) sind beispielsweise aus dem US-Patent 4 278 751 bekannt.

Bevorzugt sind Cumarine der Formel (XXIII), worin einer der Reste R₂₃ oder R₂₄ Methoxy bedeutet. Insbesondere bevorzugt ist 3-Benzoyl-7-methoxycumarin.

Auch die Aminosäuren der Formel (XXV) sind bekannt und beispielsweise in der JP-OS Hei 03-170 551 beschrieben.

Vorzugsweise wird N-Phenylglycin verwendet.

Die erfindungsgemässen Zusammensetzungen enthalten im allgemeinen 0,2-5 Gew.-% Cumarin der Formel (XXIII), 0,5-10 Gew.-% Aminosäure der Formel (XXV) und 0-20 Gew.-% der Komponente (d), bezogen auf die Komponente (a).

Weitere geeignete Sensibilisatoren, die in Kombination mit den Cumarinen der Formel (XXIII) eingesetzt werden können, sind die in der JP-OS Hei 03-170 552 beschriebenen Oxazolone.

Gegenstand der vorliegenden Erfindung sind daher auch Zusammensetzungen enthaltend
(a) ein Polymer enthaltend wiederkehrende Strukturelemente der Formel (I),
(b) ein Cumarin der Formel (XXIII),
(c) ein Oxazolon der Formel (XXVI) 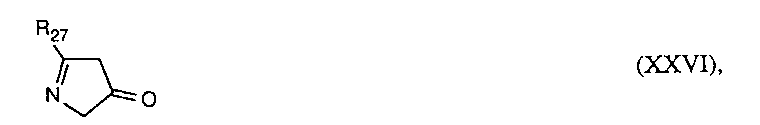 worin R₂₇ für eine Gruppe der Formeln (XXVII) oder (XXVIII) steht 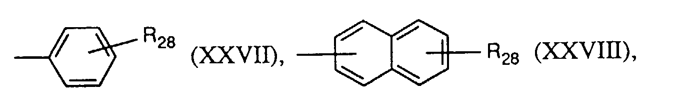 worin R₂₈ Wasserstoff, Methyl, Ethyl, n-Propyl, i-Propyl, n-Butyl, t-Butyl, Phenyl, Hydroxy, Methoxy, Ethoxy, n-Propoxy, n-Butoxy, Phenoxy, Benzyl, 2-Phenylethyl, Hydroxymethyl, 2-Hydroxyethyl, Acetyl, Propionyl, Acetyloxy, Propionyloxy, Aminomethyl, 2-Aminoethyl, Methylamino, Dimethylamino, Diethylamino, -CONH₂, -CONHCH₃, -CON(CH₃)₂, -CONHC₂H₅ oder -CON(C₂H₅)₂ bedeutet,
   und gegebenenfalls
(d) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

Das als Komponente (c) bevorzugte Oxazolon ist 3-Phenyl-5-isooxazolon. Die erfindungsgemässen Zusammensetzungen eignen sich aufgrund ihrer hohen Transparenz im i-Linien-Bereich insbesondere zur Herstellung von Reliefstrukturen nach dem oben beschriebenen Verfahren. Da diese Zusammensetzungen jedoch eine hohe Lichtempfindlichkeit in einem weiten Bereich von ca. 200 nm bis ca. 600 nm aufweisen, ist ihre Verwendung nicht auf i-Linien-Belichtung beschränkt. Es kann vielmehr aktinische Strahlung der verschiedensten Wellenlängen verwendet werden; Breitbandbelichtung ist ebenso möglich wie Bestrahlung mit diskreten Wellenlängen (z.B. g-Linie).

Die folgenden Beispiele erläutern die Erfindung.

### I. Herstellung der Polyimid-Vorstufen

### I.1. Polyamidsäureester aus Oxydiphthalsäuredianhydrid, Methacrylsäure-2-hydroxyethylester und 4,4'-Diaminodiphenylether

In einem trockenen 500 ml-Planschliff-Reaktor, ausgerüstet mit Rührer, Kühler und Innenthermometer, werden unter Feuchtigkeitsausschluss 20 g (64,5 mmol) Oxydiphthalsäuredianhydrid in 140 ml Diglyme suspendiert. Anschliessend werden 16,8 g (129 mmol) Methacrylsäure-2-hydroxyethylester, 0,05 g Hydrochinon und 10,7 g (135 mmol) Pyridin zugegeben. Nach Erwärmung auf 60 °C wird eine klare Lösung erhalten. Es wird 18 h nachgerührt.
Nach Abkühlen auf -20 °C wird 16,1 g (135,5 mmol) Thionylchlorid innerhalb von 90 min zugetropft, wobei ein weisser Niederschlag von Pyridiniumhydrochlorid entsteht. Es wird auf Raumtemperatur erwärmt und 2 h nachgerührt. Nach Zugabe von 9,7 g (123 mmol) Pyridin und 25 ml N-Methylpyrrolidon (NMP) erhält man eine klare Lösung. 11,8 g (58,7 g) 4,4'-Diaminodiphenylether werden in 100 ml NMP gelöst und innerhalb einer Stunde zur Reaktionslösung zugetropft. Dabei nimmt die Viskosität stetig zu. Es wird 2 h nachgerührt. Anschliessend wird das Polymer in 4 1 Wasser gefällt, gründlich mit Wasser gewaschen und bei 45 °C im Hochvakuum getrocknet. Man erhält ein farbloses Produkt mit folgenden physikalischen Daten:

| | |
|---|---|
| inhärente Viskosität: | ηᵢₙₕ = 0,31 dl/g |
| mittleres Molekulargewicht: | M_{w} = 25500 g/mol |
| | Mₙ = 3800 g/mol |

Die in der Literatur bisher nicht beschriebene Substanz wird anhand ihres ¹H-NMR-Spektrums identifiziert.

### I.2. Polyamidsäureester aus 3,3',4,4'-Benzophenontetracarbonsäuredianhydrid, Methacrylsäure-2-hydroxyethylester, 4,4'-Methylen-bis-(2-ethyl-6-methylanilin) (70 %) und 1,4'-Diaminodurol (30 %)

In einem trockenen 500 ml-Planschliff-Reaktor, ausgerüstet mit Rührer, Kühler und Innenthermometer, werden unter Feuchtigkeitsausschluss 22,55 g (70 mmol) 3,3',4,4'-Benzophenontetracarbonsäuredianhydrid in 140 ml Diglyme suspendiert. Anschliessend werden 18,22 g (140 mmol) Methacrylsäure-2-hydroxyethylester, 0,05 g Hydrochinon und 23,26 g (294 mmol) Pyridin zugegeben. Nach Erwärmung auf 60 °C wird eine klare Lösung erhalten. Es wird 18 h nachgerührt.
Nach Abkühlen auf -20 °C wird 17,18 g (114 mmol) Thionylchlorid innerhalb von 90 min zugetropft, wobei ein weisser Niederschlag von Pyridiniumhydrochlorid entsteht. Es wird auf 0 °C erwärmt und 1 h nachgerührt. Nach Zugabe von 25 ml NMP werden 13,84 g 4,4'-Methylen-bis-(2-ethyl-6-methylanilin) und 3,45 g 1,4-Diaminodurol in 140 ml NMP gelöst und innerhalb 1 h zur Reaktionslösung zugetropft. Dabei nimmt die Viskosität stetig zu. Es wird 1 h nachgerührt. Nach Zugabe von 25 ml Ethanol wird noch 30 min nachgerührt. Anschliessend wird das Polymer in 4 l Wasser gefällt, gründlich mit Wasser gewaschen und bei 45 °C im Hochvakuum getrocknet. Man erhält ein farbloses Produkt mit folgenden physikalischen Daten:

| | |
|---|---|
| inhärente Viskosität: | ηᵢₙₕ = 0,26 dl/g |

### I.3. Polyamidsäureester aus Oxydiphthalsäuredianhydrid, Methacrylsäure-2-hydroxyethylester, 4,4'-Methylen-bis-(2-ethyl-6-methylanilin) (70 %) und 1,4'-Diaminodurol (30 %)

Analog zu Beispiel II.2. wird ein Polyamidsäureester aus 21,71 g (70 mmol) Oxydiphthalsäuredianhydrid, 18,22 g (140 mmol) Methacrylsäure-2-hydroxyethylester, 13,56 g 4,4'-Methylen-bis-(2-ethyl-6-methylanilin) und 3,38 g 1,4-Diaminodurol hergestellt. Das farblose Produkt besitzt eine inhärente Viskosität von ηᵢₙₕ = 0,21 dl/g.

### II. Applikationsbeispiele

### II.1. Eine Formulierung, hergestellt aus

| | |
|---|---|
| 40,0 Gew.-% | Polyimid-Vorstufe gemäss Beispiel I.1 |
| 0,08 Gew.-% | 1,4-Benzochinon |
| 1.4 Gew.-% | Titanocen der Formel (XVIII) |
| 6,0 Gew.-% | Tetraethylenglykoldimethacrylat und |
| 52,52 Gew.-% | N-Methylpyrrolidon |

wird über Nacht zur klaren Harzlösung gerollt und anschliessend einer Druckfiltration durch Filter der Porenweite 0,8 µm unterzogen. Die Harzlösung wird auf mit dem Haftvermittler γ-Aminopropyltriethoxysilan vorbehandelte Siliciumwafer aufgeschleudert (3900 U/min, 25 s), und die beschichteten Wafer werden dann 5 min bei 100 °C auf einem Hotplate getrocknet. Dabei werden 15 µm starke gleichmässige Polymerschichten auf den Siliciumwafern erhalten.
Die Wafer werden anschliessend mit einer Belichtungsmaschine des Typs Karl-Süss MJB 55 im Vakuumkontakt belichtet, wobei eine Siemens-Chrommaske mit Positiv/Negativ-Strukturen bis 1 µm benutzt wird. Zur monochromatischen i-Linien-Belichtung wird die entsprechende Linie des Lampenspektrums mit einem Quecksilber-Interferenzfilter bei 365 nm ausgefiltert. Die Strahlungsleistungen werden mit einem OAI-Powermeter und der 365 nm-Sonde gemessen.
Die hochaufgelösten Feinstrukturen werden im Sprühverfahren entwickelt, wobei folgender Sprühzyklus angewendet wird:
45 s γ-Butyrolacton/Xylol (1:1)
5 s γ-Butyrolacton/Xylol (1:3)
10 s Xylol

Bei dem beschriebenen Verfahren ist eine Belichtungsenergie von 350 mJ/cm² notwendig, um gute Strukturen zu erzeugen. Es werden hochaufgelöste Reliefstrukturen mit guter Kantenschärfe erhalten, wobei 10 µm breite Linien noch aufgelöst sind. Im Rasterelektronenmikroskop zeigen die Strukturen eine homogene Materialbeschaffenheit. Die Proben werden 60 min bei 350 °C getempert, wobei die Schichtdicke auf 9,5 µm abnimmt. Dabei bleiben Auflösung und Kantenschärfe unverändert. Die Strukturen weisen eine hervorragende Haftung auf dem Substrat auf und sind frei von Blasen und Cracks.

### II.2. Eine Formulierung, hergestellt aus

| | |
|---|---|
| 35,5 Gew.-% | Polyimid-Vorstufe gemäss Beispiel I.2 |
| 0,08 Gew.-% | 1,4-Benzochinon |
| 1.24 Gew.-% | Titanocen der Formel (XVIII) |
| 5,32 Gew.-% | Tetraethylenglykoldimethacrylat und |
| 57,86 Gew.-% | N-Methylpyrrolidon |

wird über Nacht zur klaren Harzlösung gerollt und anschliessend einer Druckfiltration durch Filter der Porenweite 0,8 µm unterzogen. Die Harzlösung wird auf mit dem Haftvermittler γ-Aminopropyltriethoxysilan vorbehandelte Siliciumwafer aufgeschleudert (2200 U/min, 30 s), und die beschichteten Wafer werden dann 5 min bei 100 °C auf einem Hotplate getrocknet. Dabei werden 15 µm starke gleichmässige Polymerschichten auf den Siliciumwafern erhalten.
Die Wafer werden anschliessend mit einer Belichtungsmaschine des Typs Karl-Süss MJB 55 im Vakuumkontakt belichtet, wobei eine Siemens-Chrommaske mit Positiv/Negativ-Strukturen bis 1 µm benutzt wird. Zur monochromatischen i-Linien-Belichtung wird die entsprechende Linie des Lampenspektrums mit einem Quecksilber-Interferenzfilter bei 365 nm ausgefiltert. Die Strahlungsleistungen werden mit einem OAI-Powermeter und der 365 nm-Sonde gemessen.
Die hochaufgelösten Feinstrukturen werden im Sprühverfahren entwickelt, wobei folgender Sprühzyklus angewendet wird:
60 s γ-Butyrolacton/Xylol (1:1)
5 s γ-Butyrolacton/Xylol (1:3)
15 s Xylol

Bei dem beschriebenen Verfahren ist eine Belichtungsenergie von 200 mJ/cm² notwendig, um gute Strukturen zu erzeugen. Es werden hochaufgelöste Reliefstrukturen mit guter Kantenschärfe erhalten, wobei 10 µm breite Linien noch aufgelöst sind. Im Rasterelektronenmikroskop zeigen die Strukturen eine homogene Materialbeschaffenheit. Die Proben werden 60 min bei 350 °C getempert, wobei die Schichtdicke auf 10,7 µm abnimmt. Dabei bleiben Auflösung und Kantenschärfe unverändert. Die Strukturen weisen eine hervorragende Haftung auf dem Substrat auf und sind frei von Blasen und Cracks.

### II.3. Analog zu Beispiel II.2. wird eine Formulierung aus

| | |
|---|---|
| 33,54 Gew.-% | Polyimid-Vorstufe gemäss Beispiel I.2 |
| 0,07 Gew.-% | 1,4-Benzochinon |
| 1.68 Gew.-% | Triketonoximester der Formel (XXa) |
| 0,67 Gew.-% | N-Phenyldiethanolamin |
| 0,67 Gew.-% | 2-Mercaptobenzothiazol |
| 5,03 Gew.-% | Tetraethylenglykoldimethacrylat und |
| 58,34 Gew.-% | N-Methylpyrrolidon |

hergestellt und auf mit dem Haftvermittler γ-Aminopropyltriethoxysilan vorbehandelte Siliciumwafer aufgeschleudert (2200 U/min, 30 s). Die so erhaltenen 15 µm starken Polymerschichten werden anschliessend analog zu Applikationsbeispiel II.1. verarbeitet, wobei eine Belichtungsenergie von 550 mJ/cm² (365 nm, i-Linie) erforderlich ist. Es werden hochaufgelöste Reliefstrukturen mit guter Kantenschärfe erhalten, wobei 8 µm breite Linien noch aufgelöst sind. Die Proben werden 60 min bei 350 °C getempert, wobei die Schichtdicke auf 8,5 µm abnimmt. Dabei bleiben Auflösung und Kantenschärfe unverändert.

### II.4. Analog zu Beispiel II.2. wird eine Formulierung aus

| | |
|---|---|
| 33,54 Gew.-% | Polyimid-Vorstufe gemäss Beispiel I.2 |
| 0,07 Gew.-% | 1,4-Benzochinon |
| 1.67 Gew.-% | Triketonoximester der Formel (XXa) |
| 0,67 Gew.-% | N-Phenyldiethanolamin |
| 0,67 Gew.-% | 2-Mercaptobenzothiazol |
| 0,20 Gew.-% | Cumarin der Formel (XXIIa) |
| 5,02 Gew.-% | Tetraethylenglykoldimethacrylat und |
| 58,23 Gew.-% | N-Methylpyrrolidon |

hergestellt und auf mit dem Haftvermittler γ-Aminopropyltriethoxysilan vorbehandelte Siliciumwafer aufgeschleudert (2200 U/min, 30 s). Dabei werden 15 µm starke gleichmässige Polymerschichten auf den Siliciumwafern erhalten.
Die Wafer werden anschliessend mit einer Belichtungsmaschine des Typs Karl-Süss MJB 55 bei zwei verschiedenen Wellenlängen im Vakuumkontakt belichtet:
a) ein Teil der Wafer wird mit Licht der Wellenlänge 365 nm bestrahlt (i-Linie, erzeugt mittels eines Interferenzfilters der Wellenlänge 365 nm, Belichtungsenergie: 600 mJ/cm², gemessen mit der 365 nm-Sonde eines OAI-Powermeters);
b) der zweite Teil der Wafer wird mit Licht der Wellenlänge 436 nm bestrahlt (g-Linie, erzeugt mittels eines Interferenzfilters der Wellenlänge 436 nm, Belichtungsenergie: 750 mJ/cm², gemessen mit der 365 nm-Sonde eines OAI-Powermeters).
   Anschliessend werden die belichteten Wafer analog zu Beispiel II.1. entwickelt, wobei sowohl nach i-Linien-als auch nach g-Linien-Belichtung hochaufgelöste Strukturen der Linienbreite 8 µm erhalten werden, die nach Temperung (60 min bei 350 °C) eine Schichtdicke von 8,3 nm aufweisen.

### II.5. Eine Formulierung, hergestellt aus

| | |
|---|---|
| 34,23 Gew.-% | Polyimid-Vorstufe gemäss Beispiel I.1 |
| 0,07 Gew.-% | 1,4-Benzochinon |
| 0,34 Gew.-% | 3-Benzoyl-7-methoxycumarin |
| 1,71 Gew.-% | N-Phenylglycin |
| 4,11 Gew.-% | Polyethylenglykol-400-diacrylat und |
| 59,54 Gew.-% | N-Methylpyrrolidon |

wird über Nacht zur klaren Harzlösung gerollt und anschliessend einer Druckfiltration durch Filter der Porenweite 0,8 µm unterzogen. Die Harzlösung wird auf mit dem Haftvermittler γ-Aminopropyltriethoxysilan vorbehandelte Siliciumwafer aufgeschleudert (1500 U/min, 9 s), und die beschichteten Wafer werden dann 5 min bei 100 °C auf einem Hotplate getrocknet. Dabei werden 15 µm starke gleichmässige Polymerschichten auf den Siliciumwafern erhalten.
Die Wafer werden anschliessend mit einer Belichtungsmaschine des Typs Karl-Süss MA 150 im Vakuumkontakt belichtet, wobei eine Siemens-Chrommaske mit Positiv/Negativ-Strukturen bis 1 µm benutzt wird. Zur monochromatischen i-Linien-Belichtung wird die entsprechende Linie des Lampenspektrums mit einem Quecksilber-Interferenzfilter bei 365 nm ausgefiltert. Die Strahlungsleistungen werden mit einem OAI-Powermeter und der 365 nm-Sonde gemessen.
Die hochaufgelösten Feinstrukturen werden im Sprühverfahren entwickelt, wobei folgender Sprühzyklus angewendet wird:
35 s γ-Butyrolacton/Xylol (1:1)
5 s γ-Butyrolacton/Xylol (1:3)
15 s Xylol

Bei dem beschriebenen Verfahren ist eine Belichtungsenergie von 350 mJ/cm² notwendig, um gute Strukturen zu erzeugen. Es werden hochaufgelöste Reliefstrukturen mit guter Kantenschärfe erhalten, wobei 10 µm breite Linien noch aufgelöst sind. Im Rasterelektronenmikroskop zeigen die Strukturen eine homogene Materialbeschaffenheit. Die Proben werden 60 min bei 350 °C getempert, wobei die Schichtdicke auf 9,5 µm abnimmt. Dabei bleiben Auflösung und Kantenschärfe unverändert. Die Strukturen weisen eine hervorragende Haftung auf dem Substrat auf und sind frei von Blasen und Cracks.

### II.6. Eine Formulierung, hergestellt aus

| | |
|---|---|
| 33,88 Gew.-% | Polyimid-Vorstufe gemäss Beispiel I.1 |
| 0,07 Gew.-% | 1,4-Benzochinon |
| 0,34 Gew.-% | 3-Benzoyl-7-methoxycumarin |
| 1,69 Gew.-% | N-Phenylglycin |
| 5,09 Gew.-% | Polyethylenglykol-400-diacrylat und |
| 58,93 Gew.-% | N-Methylpyrrolidon |

wird über Nacht zur klaren Harzlösung gerollt und anschliessend einer Druckfiltration durch Filter der Porenweite 0,8 µm unterzogen. Die Harzlösung wird auf mit dem Haftvermittler γ-Aminopropyltriethoxysilan vorbehandelte Siliciumwafer aufgeschleudert (1500 U/min, 9 s), und die beschichteten Wafer werden dann 6 min bei 70 °C und 6 min bei 100 °C auf einem Hotplate getrocknet. Dabei werden 40 µm starke gleichmässige Polymerschichten auf den Siliciumwafern erhalten.
Die Wafer werden anschliessend mit einer Belichtungsmaschine des Typs Karl-Süss MA 150 im Vakuumkontakt belichtet, wobei eine Siemens-Chrommaske mit Positiv/Negativ-Strukturen bis 1 µm benutzt wird. Zur monochromatischen i-Linien-Belichtung wird die entsprechende Linie des Lampenspektrums mit einem Quecksilber-Interferenzfilter bei 365 nm ausgefiltert. Die Strahlungsleistungen werden mit einem OAI-Powermeter und der 365 nm-Sonde gemessen.
Die hochaufgelösten Feinstrukturen werden im Sprühverfahren entwickelt, wobei folgender Sprühzyklus angewendet wird:
75 s γ-Butyrolacton/Xylol (1:1)
10 s γ-Butyrolacton/Xylol (1:3)
15 s Xylol

Bei dem beschriebenen Verfahren ist eine Belichtungsenergie von 500 mJ/cm² notwendig, um gute Strukturen zu erzeugen. Es werden hochaufgelöste Reliefstrukturen mit guter Kantenschärfe erhalten, wobei 40 µm breite Linien noch aufgelöst sind. Im Rasterelektronenmikroskop zeigen die Strukturen eine homogene Materialbeschaffenheit. Die Proben werden 60 min bei 350 °C getempert, wobei die Schichtdicke auf 25 µm abnimmt. Dabei bleiben Auflösung und Kantenschärfe unverändert. Die Strukturen weisen eine hervorragende Haftung auf dem Substrat auf und sind frei von Blasen und Cracks.

### II.7. Eine Formulierung, hergestellt aus

| | |
|---|---|
| 42,92 Gew.-% | Polyimid-Vorstufe gemäss Beispiel I.3. |
| 0,09 Gew.-% | 1,4-Benzochinon |
| 2,15 Gew.-% | Irgacure 369 |
| 6,44 Gew.-% | Tetraethylenglykoldimethacrylat und |
| 48,40 Gew.-% | N-Methylpyrrolidon |

wird analog zu Applikationsbeispiel II.1. verarbeitet, wobei die Schleuderbeschichtung bei 2900 U/min, 35 s erfolgt. Die nach dem Trocknen (100 °C, 5 min) erhaltenen 15 µm starken Schichten werden dann mit UV-Strahlung belichtet (365 nm, 1880 mJ/cm²) und im Sprühverfahren entwickelt, wobei folgender Sprühzyklus angewendet wird:
95 s γ-Butyrolacton/Xylol (1:1)
10 s γ-Butyrolacton/Xylol (1:3)
10 s Xylol.

Es werden hochaufgelöste Reliefstrukturen mit guter Kantenschärfe erhalten, wobei 5 µm breite Linien noch gut aufgelöst sind und die Schichtdicke 14,8 µm beträgt

## Patentansprüche (Patentansprüche für folgende(n) Vertragsstaat(en): BE, CH, LI, NL)

1. Verfahren zur Herstellung von Reliefabbildungen, umfassend die folgenden Schritte:
(A) Beschichten eines Substrats mit einer photopolymerisierbaren Zusammensetzung enthaltend ein Polymer (a) und einen Photoinitiator (b),
(B) bildmässiges Belichten des beschichteten Substrats mit UV-Strahlung im i-Linien-Bereich (ca. 360-370 nm),
(C) Entfernen der unbelichteten Stellen mit Hilfe eines Lösungsmittels und
(D) Tempern des belichteten und entwickelten Materials,
dadurch gekennzeichnet, dass als Polymer (a) eine Polyimid-Vorstufe enthaltend wiederkehrende Strukturelemente der Formel (I) verwendet wird, 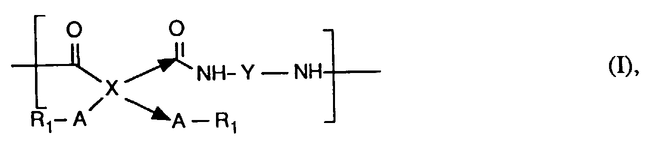 worin → für Strukturisomere steht, X den vierwertigen Rest einer aromatischen Tetracarbonsäure darstellt, Y für einen zweiwertigen aliphatischen, cycloaliphatischen oder ein- oder mehrkernigen aromatischen Rest steht, A für -COO-, -CONH- oder -COO^{⊖}HN^{⊕}R₂R₃- steht, worin R₂ und R₃ unabhängig voneinander C₁-C₆-Alkyl oder C₁-C₆-Alkenyl bedeuten, und R₁ ein Rest mit einer photopolymerisierbaren olefinischen Doppelbindung ist,
mit der Massgabe, dass mindestens 50 % aller Reste X den Rest er Oxydiphthalsäure oder mindestens 50 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy, oder C₆-C₁₄-Aryl substituiert ist.

2. Verfahren nach Anspruch 1, dadurch gekennzeichnet, dass als Polymer (a) eine Polyimid-Vorstufe enthaltend wiederkehrende Strukturelemente der Formel (I) verwendet wird, worin mindestens 50 % aller Reste X den Rest der Oxydiphthalsäure darstellen und Y die gleiche Bedeutung wie in Anspruch 1 hat.

3. Verfahren nach Anspruch 1, dadurch gekennzeichnet, dass als Polymer (a) eine Polyimid-Vorstufe enthaltend wiederkehrende Strukturelemente der Formel (I) verwendet wird, worin mindestens 80 % aller Reste X den Rest der Oxydiphthalsäure darstellen.

4. Verfahren nach Anspruch 1, dadurch gekennzeichnet, dass als Polymer (a) eine Polyimid-Vorstufe enthaltend wiederkehrende Strukturelemente der Formel (I) verwendet wird, worin 100 % aller Reste X den Rest der Oxydiphthalsäure darstellen.

5. Verfahren nach Anspruch 1, dadurch gekennzeichnet, dass als Polymer (a) eine Polyimid-Vorstufe enthaltend wiederkehrende Strukturelemente der Formel (I) verwendet wird, worin A -COO-bedeutet und R₁ für Vinyl, Allyl, Methallyl oder für einen Rest der Formel (II) steht 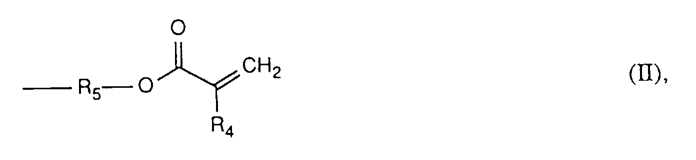 worin R₄ Wasserstoff oder Methyl bedeutet und R₅ für -CₙH₂ₙ- mit n = 2-12, -CH₂CH(OH)CH₂- oder Polyoxyalkylen mit 4-30 C-Atomen steht

6. Verfahren nach Anspruch 2, dadurch gekennzeichnet, dass als Polymer (a) eine Polyimid-Vorstufe enthaltend wiederkehrende Strukturelemente der Formel (I) verwendet wird, worin Y einen unsubstituierten oder durch einen oder mehrere C₁-C₆-Alkylgruppen oder C₁-C₆-Alkoxygruppen substituierten Rest der Formeln (m)-(V) bedeutet 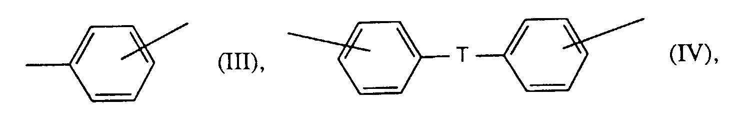 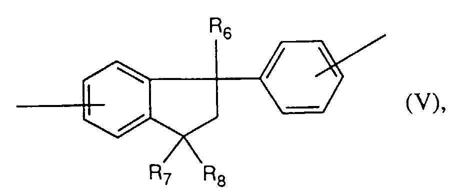 worin T für eine direkte Bindung, -CH₂-, C₂-C₁₂-Alkyliden, -C(CF₃)₂-, -NH-, -S-, -O-, -SO-, -SO₂- oder -CO- steht und R₆, R₇ und R₈ unabhängig voneinander Wasserstoff oder C₁-C₆-Alkyl bedeuten.

7. Verfahren nach Anspruch 2, dadurch gekennzeichnet, dass als Polymer (a) eine Polyimid-Vorstufe enthaltend wiederkehrende Strukturelemente der Formel (I) verwendet wird, worin Y für einen Rest der Formeln (VI)-(VIII) steht

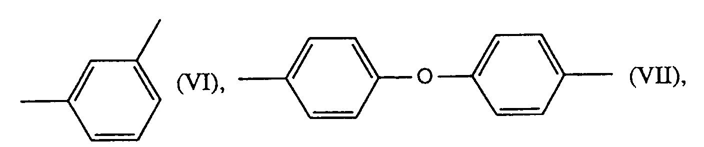

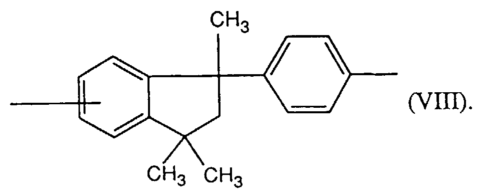

8. Verfahren nach Anspruch 1, dadurch gekennzeichnet, dass als Polymer (a) eine Polyimid-Vorstufe enthaltend wiederkehrende Strukturelemente der Formel (I) verwendet wird, worin mindestens 50 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist, und X die in Anspruch 1 angegeben Bedeutung hat.

9. Verfahren nach Anspruch 1, dadurch gekennzeichnet, dass als Polymer (a) eine Polyimid-Vorstufe enthaltend wiederkehrende Strukturelemente der Formel (I) verwendet wird, worin mindestens 80 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist.

10. Verfahren nach Anspruch 1, dadurch gekennzeichnet, dass als Polymer (a) eine Polyimid-Vorstufe enthaltend wiederkehrende Strukturelemente der Formel (I) verwendet wird, worin 100 % Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist.

11. Verfahren nach Anspruch 8, dadurch gekennzeichnet, dass als Polymer (a) eine Polyimid-Vorstufe enthaltend wiederkehrende Strukturelemente der Formel (I) verwendet wird, worin Y für einen Rest der Formeln (IX), (X) oder (XI) steht, 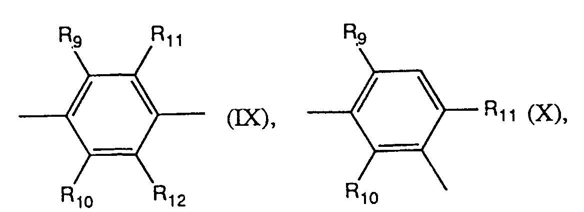 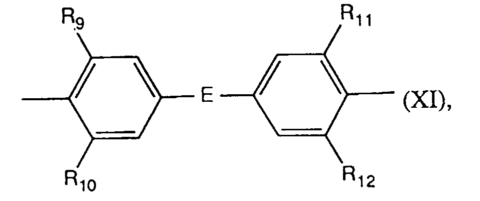 worin R₉, R₁₀, R₁₁ und R₁₂ unabhängig voneinander C₁-C₆-Alkyl bedeuten und E für eine direkte Bindung, -CH₂-, C₂-C₁₂-Alkyliden, -C(CF₃)₂-, -NH-, -S-, -O-, -SO-, -SO₂- oder -CO- steht.

12. Verfahren nach Anspruch 8, dadurch gekennzeichnet, dass als Polymer (a) eine Polvimid-Vorstufe enthaltend wiederkehrende Strukturelemente der Formel (I) verwendet wird, worin Y für 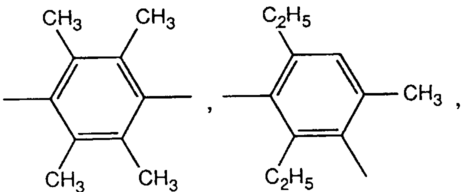 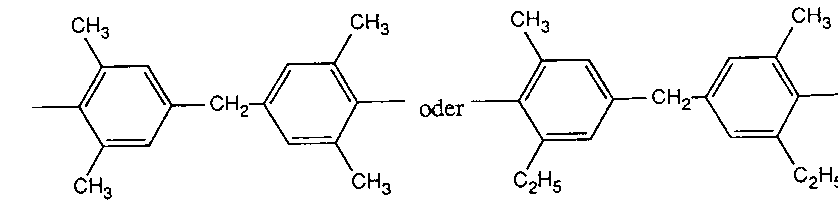 steht.

13. Verfahren nach Anspruch 8, dadurch gekennzeichnet, dass als Polymer (a) eine Polyimid-Vorstufe enthaltend wiederkehrende Strukturelemente der Formel (I) verwendet wird, worin X den Rest der Pyromellitsäure, der 3,3',4,4'-Biphenyltetracarbonsäure, der Oxydiphthalsäure, der 3,3',4,4'-Benzophenontetracarbonsäure, oder der Hexafluorisopropylidendiphthalsäure bedeutet.

14. Zusammensetzung enthaltend
(a) ein Polymer enthaltend wiederkehrende Strukturelemente der Formel (I) gemäss Anspruch 1, und
(b) ein Titanocen der Formel (XIV) 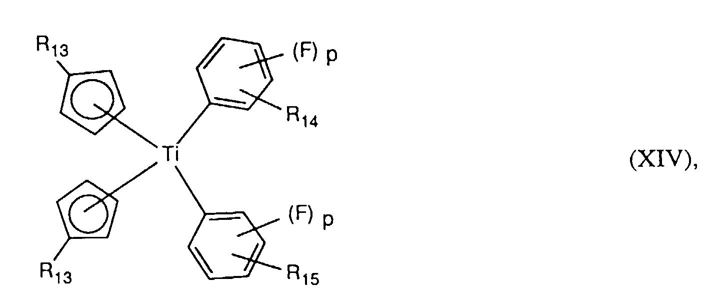 worin beide Reste R₁₃ unabhängig voneinander Wasserstoff oder C₁-C₆-Alkyl bedeuten, R₁₄ und R₁₅ für C₁-C₆-Alkyl, C₆-C₁₄-Aryl oder einen heterocyclischen fünf- oder sechsgliedrigen aliphatischen oder aromatischen Ring stehen und p eine Zahl von 2 bis 5 ist, mit der Massgabe, dass jeweils zwei Fluoratome die ortho-Positionen der beiden Phenylringe besetzen.

15. Zusammensetzung nach Anspruch 14 enthaltend als Komponente (b) ein Titanocen der Formeln (XV)-(XVIII)

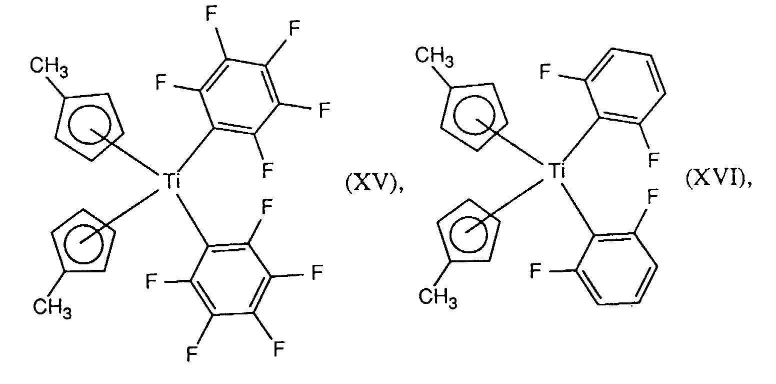

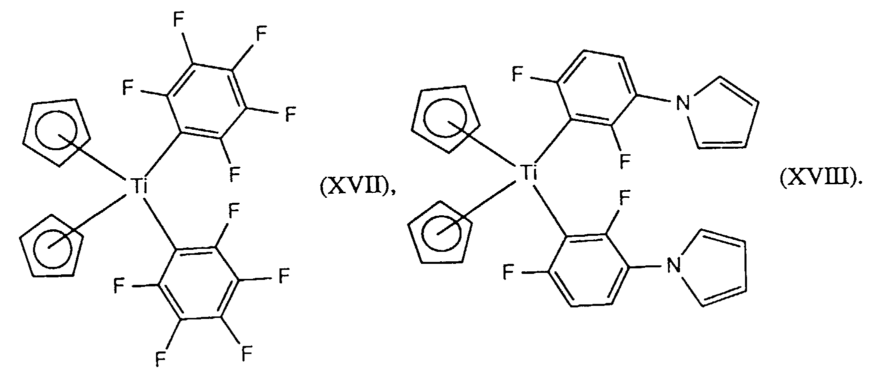

16. Zusammensetzung nach Anspruch 14, enthaltend zusätzlich
(c) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

17. Zusammensetzung enthaltend
(a) ein Polymer enthaltend wiederkehrende Strukturelemente der Formel (I) gemäss Anspruch 1,
(b) ein Triketonoximester der Formel (XX) 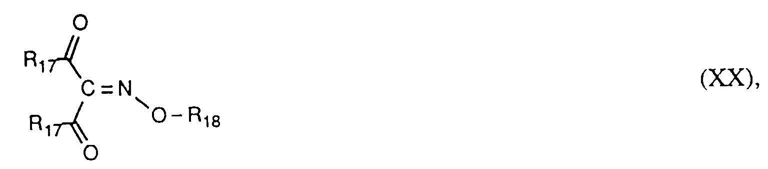 worin die Reste R₁₇ unabhängig voneinander für p-Tolyl, p-Alkoxyphenyl oder Mesityl stehen und R₁₈ C₁-C₆-Alkylcarbonyl, C₁-C₆-Alkoxycarbonyl, C₆-C₁₄-Arylcarbonyl oder C₆-C₁₄-Aryloxycarbonyl bedeutet, und
(c) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

18. Zusammensetzung nach Anspruch 17, enthaltend zusätzlich
(d) ein aromatisches Amin der Formel (XXI) 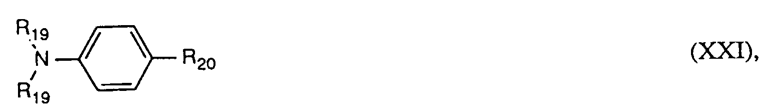 bedeutet, worin die beiden R₁₉ unabhängig voneinander für C₁-C₃-Alkyl oder C₁-C₃-Hydroxyalkyl stehen oder zusammen mit dem N-Atom eine Morpholingruppe bilden und R₂₀ eine C₁-C₃-Alkylgruppe, C₂-C₅-Alkylcarbonylgruppe oder C₇-C₁₀-Arylcarbonylgruppe darstellt.

19. Zusammensetzung nach Anspruch 18, enthaltend zusätzlich
(e) ein Cumarin der Formel (XXII) 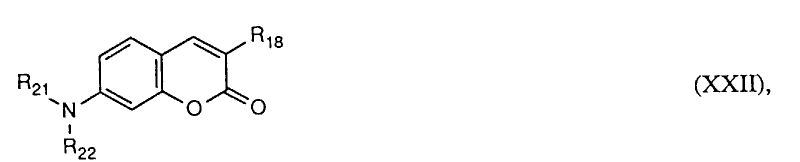 steht, worin R₂₁ und R₂₂ unabhängig voneinander C₁-C₆-Alkylgruppen sind und R₁₈ C₁-C₆-Alkylcarbonyl, C₁-C₆-Alkoxycarbonyl, C₆-C₁₄-Arylcarbonyl oder C₆-C₁₄-Aryloxycarbonyl bedeutet.

20. Zusammensetzung enthaltend
(a) ein Polymer enthaltend wiederkehrende Strukturelemente der Formel (I) gemäss Anspruch 1,
(b) ein Cumarin der Formel (XXIII) 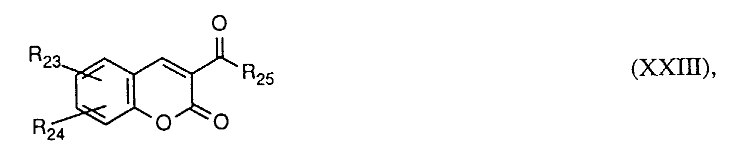 worin R₂₃ und R₂₄ unabhängig voneinander Wasserstoff oder C₁-C₆-Alkoxy bedeuten und R₂₅ für C₆-C₁₄-Aryl oder einen Rest der Formel (XXIV) steht 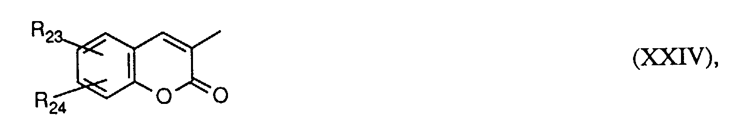 worin R₂₃ und R₂₄ die gleiche Bedeutung wie in Formel (XXIII) haben, und
(c) eine Aminosäure der Formel (XXV) 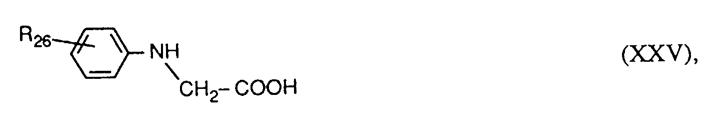 worin R₂₆ für Wasserstoff, Methyl, Ethyl, i-Propyl, t-Butyl, Phenyl, Methoxy, Ethoxy, Hydroxy, Hydroxymethyl, Dimethylamino, Diethylamino, Acetyl, Propionyl, Acetyloxy, Propionyloxy, -NHCONH₂ oder -NHCOOCH₃ steht, und gegebenenfalls
(d) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

21. Zusammensetzung enthaltend
(a) ein Polymer enthaltend wiederkehrende Strukturelemente der Formel (I) gemäss Anspruch 1,
(b) ein Cumarin der Formel (XXIII) gemäss Anspruch 20,
(c) ein Oxazolon der Formel (XXVI) 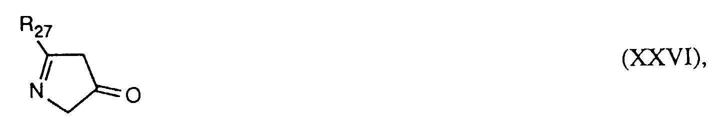 worin R₂₇ für eine Gruppe der Formeln (XXVII) oder (XXVIII) steht 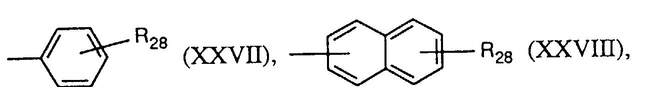 worin R₂₈ Wasserstoff, Methyl, Ethyl, n-Propyl, i-Propyl, n-Butyl, t-Butyl, Phenyl, Hydroxy, Methoxy, Ethoxy, n-Propoxy, n-Butoxy, Phenoxy, Benzyl, 2-Phenylethyl, Hydroxymethyl, 2-Hydroxyethyl, Acetyl, Propionyl, Acetyloxy, Propionyloxy, Aminomethyl, 2-Aminoethyl, Methylamino, Dimethylamino, Diethylamino, -CONH₂, -CONHCH₃, -CON(CH₃)₂, -CONHC₂H₅ oder -CON(C₂H₅)₂ bedeutet, und gegebenenfalls
(d) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

## Patentansprüche (Patentansprüche für folgende(n) Vertragsstaat(en): DE, FR, GB, IT)

1. Verfahren zur Herstellung von Reliefabbildungen, umfassend die folgenden Schritte:
(A) Beschichten eines Substrats mit einer photopolymerisierbaren Zusammensetzung enthaltend ein Polymer (a) und einen Photoinitiator (b),
(B) bildmässiges Belichten des beschichteten Substrats mit UV-Strahlung im i-Linien-Bereich (ca. 360-370 nm),
(C) Entfernen der unbelichteten Stellen mit Hilfe eines Lösungsmittels und
(D) Tempern des belichteten und entwickelten Materials,
wobei als Polymer (a) eine Polyimid-Vorstufe enthaltend wiederkehrende Strukturelemente der Formel (I) verwendet wird, 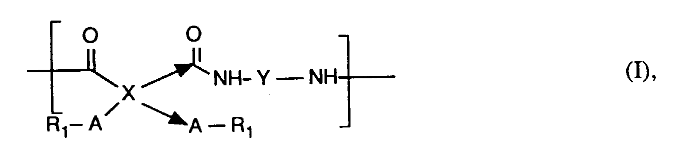 worin → für Strukturisomere steht, X den vierwertigen Rest einer aromatischen Tetracarbonsäure darstellt, Y für einen zweiwertigen aliphatischen, cycloaliphatischen oder ein- oder mehrkernigen aromatischen Rest steht, A für -COO-, -CONH- oder -COO^{⊖}HN^{⊕}R₂R₃- steht, worin R₂ und R₃ unabhängig voneinander C₁-C₆-Alkyl oder C₁-C₆-Alkenyl bedeuten, und R₁ ein Rest mit einer photopolymerisierbaren olefinischen Doppelbindung ist,
mit der Massgabe, dass mindestens 50 % aller Reste X den Rest der Oxydiphthalsäure oder mindestens 50 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy, oder C₆-C₁₄-Aryl substituiert ist, und wobei als Komponente (b) ein Titanocen der Formel (XIV) oder ein Cumarin der Formel (XXIII) verwendet wird 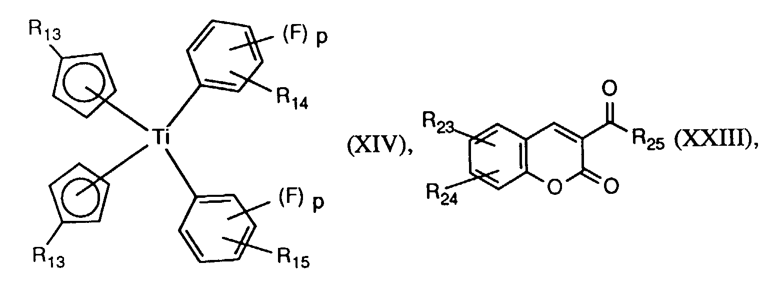 worin beide Reste R₁₃ unabhängig voneinander Wasserstoff oder C₁-C₆-Alkyl bedeuten, R₁₄ und R₁₅ für C₁-C₆-Alkyl, C₆-C₁₄-Aryl oder einen heterocyclischen fünf- oder sechsgliedrigen aliphatischen oder aromatischen Ring stehen und p eine Zahl von 2 bis 5 ist, mit der Massgabe, dass jeweils zwei Fluoratome die ortho-Positionen der beiden Phenylringe besetzen;
worin R₂₃ und R₂₄ unabhängig voneinander Wasserstoff oder C₁-C₆-Alkoxy bedeuten und R₂₅ für C₆-C₁₄-Aryl oder einen Rest der Formel (XXIV) steht 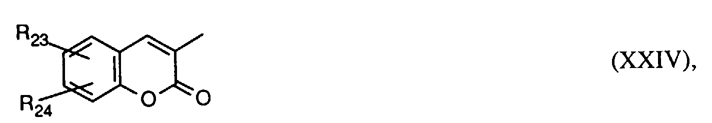 worin R₂₃ und R₂₄ die gleiche Bedeutung wie in Formel (XXIII) haben.

2. Verfahren nach Anspruch 1, dadurch gekennzeichnet, dass als Polymer (a) eine Polyimid-Vorstufe enthaltend wiederkehrende Strukturelemente der Formel (I) verwendet wird, worin mindestens 50 % aller Reste X den Rest der Oxydiphthalsäure darstellen und Y die gleiche Bedeutung wie in Anspruch 1 hat.

3. Verfahren nach Anspruch 1, dadurch gekennzeichnet, dass als Polymer (a) eine Polyimid-Vorstufe enthaltend wiederkehrende Strukturelemente der Formel (I) verwendet wird, worin mindestens 80 % aller Reste X den Rest der Oxydiphthalsäure darstellen.

4. Verfahren nach Anspruch 1, dadurch gekennzeichnet, dass als Polymer (a) eine Polyimid-Vorstufe enthaltend wiederkehrende Strukturelemente der Formel (I) verwendet wird, worin 100 % aller Reste X den Rest der Oxydiphthalsäure darstellen.

5. Verfahren nach Anspruch 1, dadurch gekennzeichnet, dass als Polymer (a) eine Polyimid-Vorstufe enthaltend wiederkehrende Strukturelemente der Formel (I) verwendet wird, worin A -COO-bedeutet und R₁ für Vinyl, Allyl, Methallyl oder für einen Rest der Formel (II) steht 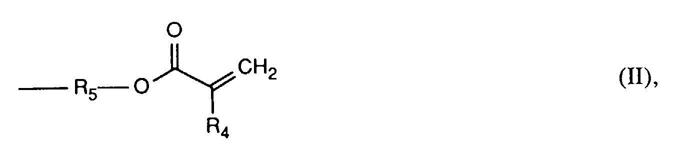 worin R₄ Wasserstoff oder Methyl bedeutet und R₅ für -CₙH₂ₙ- mit n = 2-12, -CH₂CH(OH)CH₂- oder Polyoxyalkylen mit 4-30 C-Atomen steht.

6. Verfahren nach Anspruch 2, dadurch gekennzeichnet, dass als Polymer (a) eine Polyimid-Vorstufe enthaltend wiederkehrende Strukturelemente der Formel (I) verwendet wird, worin Y einen unsubstituierten oder durch einen oder mehrere C₁-C₆-Alkylgruppen oder C₁-C₆-Alkoxygruppen substituierten Rest der Formeln (III)-(V) bedeutet 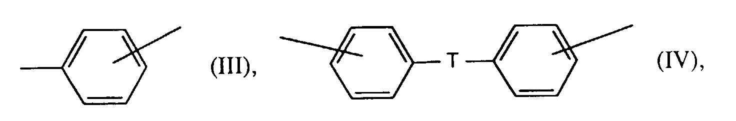 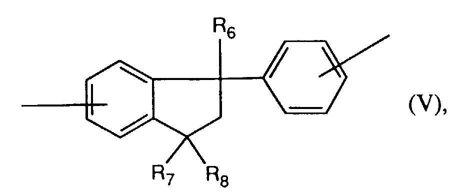 worin T für eine direkte Bindung, -CH₂-, C₂-C₁₂-Alkyliden, -C(CF₃)₂-, -NH-, -S-, -O-, -SO-, -SO₂- oder -CO- steht und R₆, R₇ und R₈ unabhängig voneinander Wasserstoff oder C₁-C₆-Alkyl bedeuten.

7. Verfahren nach Anspruch 2, dadurch gekennzeichnet, dass als Polymer (a) eine Polyimid-Vorstufe enthaltend wiederkehrende Strukturelemente der Formel (I) verwendet wird, worin Y für einen Rest der Formeln (VI)-(VIII) steht

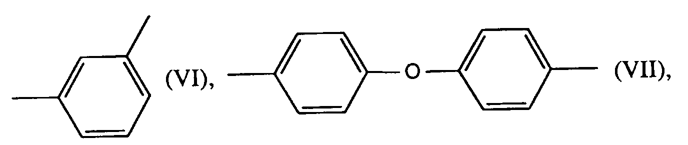

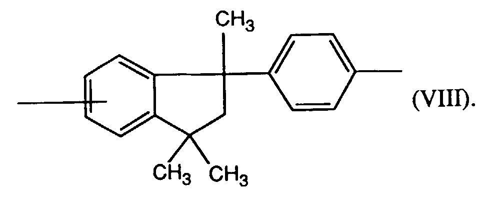

8. Verfahren nach Anspruch 1, dadurch gekennzeichnet, dass als Polymer (a) eine Polyimid-Vorstufe enthaltend wiederkehrende Strukturelemente der Formel (I) verwendet wird, worin mindestens 50 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist, und X die in Anspruch 1 angegeben Bedeutung hat.

9. Verfahren nach Anspruch 1, dadurch gekennzeichnet, dass als Polymer (a) eine Polyimid-Vorstufe enthaltend wiederkehrende Strukturelemente der Formel (I) verwendet wird, worin mindestens 80 % aller Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist.

10. Verfahren nach Anspruch 1, dadurch gekennzeichnet, dass als Polymer (a) eine Polyimid-Vorstufe enthaltend wiederkehrende Strukturelemente der Formel (I) verwendet wird, worin 100 % Reste Y einen Rest eines aromatischen Diamins darstellen, das an allen vier ortho-Positionen zu den beiden Aminstickstoffatomen unabhängig voneinander durch C₁-C₆-Alkyl, C₁-C₆-Alkoxy oder C₆-C₁₄-Aryl substituiert ist.

11. Verfahren nach Anspruch 8, dadurch gekennzeichnet, dass als Polymer (a) eine Polyimid-Vorstufe enthaltend wiederkehrende Strukturelemente der Formel (I) verwendet wird, worin Y für einen Rest der Formeln (IX), (X) oder (XI) steht, 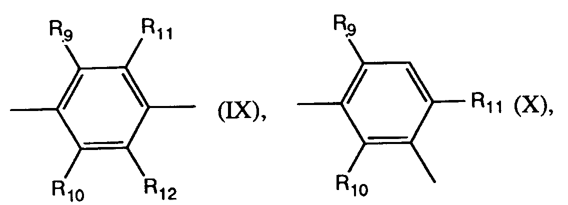 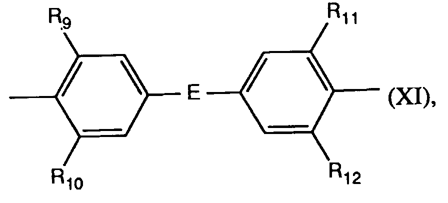 worin R₉, R₁₀, R₁₁ und R₁₂ unabhängig voneinander C₁-C₆-Alkyl bedeuten und E für eine direkte Bindung, -CH₂-, C₂-C₁₂-Alkyfiden, -C(CF₃)₂-, -NH-, -S-, -O-, -SO-, -SO₂- oder -CO- steht.

12. Verfahren nach Anspruch 8, dadurch gekennzeichnet, dass als Polymer (a) eine Polvimid-Vorstufe enthaltend wiederkehrende Strukturelemente der Formel (I) verwendet wird, worin Y für 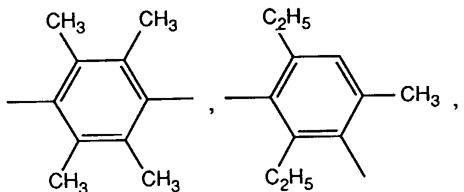 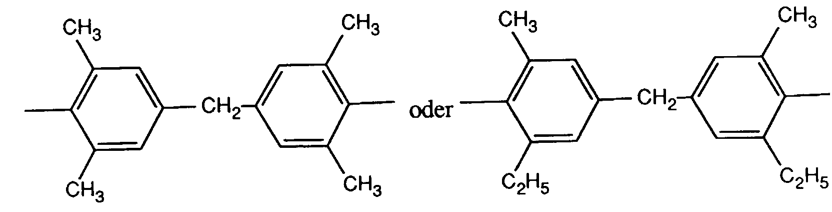 steht.

13. Verfahren nach Anspruch 8, dadurch gekennzeichnet, dass als Polymer (a) eine Polyimid-Vorstufe enthaltend wiederkehrende Strukturelemente der Formel (I) verwendet wird, worin X den Rest der Pyromellitsäure, der 3,3',4,4'-Biphenyltetracarbonsäure, der Oxydiphthalsäure, der 3,3',4,4'-Benzophenontetracarbonsäure, oder der Hexafluorisopropylidendiphthalsäure bedeutet.

14. Zusammensetzung enthaltend
(a) ein Polymer enthaltend wiederkehrende Strukturelemente der Formel (I) gemäss Anspruch 1, und
(b) ein Titanocen der Formel (XIV) 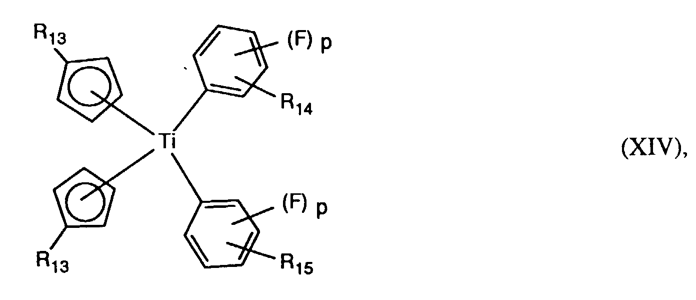 worin beide Reste R₁₃ unabhängig voneinander Wasserstoff oder C₁-C₆-Alkyl bedeuten, R₁₄ und R₁₅ für C₁-C₆-Alkyl, C₆-C₁₄-Aryl oder einen heterocyclischen fünf- oder sechsgliedrigen aliphatischen oder aromatischen Ring stehen und p eine Zahl von 2 bis 5 ist, mit der Massgabe, dass jeweils zwei Fluoratome die ortho-Positionen der beiden Phenylringe besetzen.

15. Zusammensetzung nach Anspruch 14 enthaltend als Komponente (b) ein Titanocen der Formeln (XV)-(XVIII)

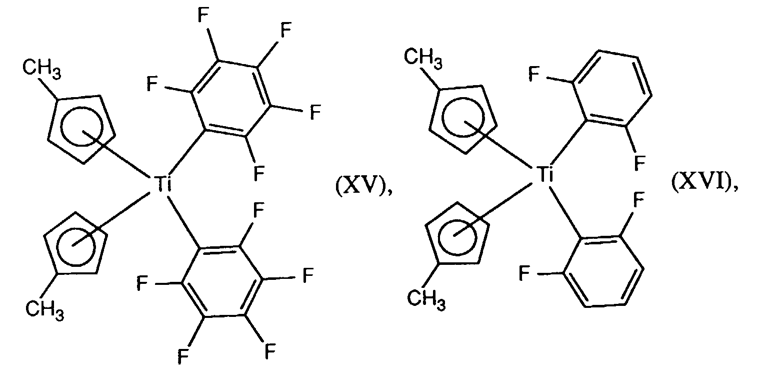

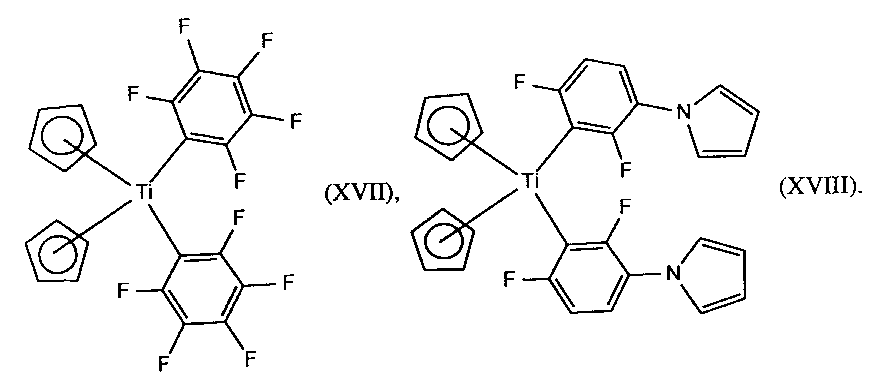

16. Zusammensetzung nach Anspruch 14, enthaltend zusätzlich
(c) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

17. Zusammensetzung enthaltend
(a) ein Polymer enthaltend wiederkehrende Strukturelemente der Formel (I) gemäss Anspruch 1,
(b) ein Triketonoximester der Formel (XX) 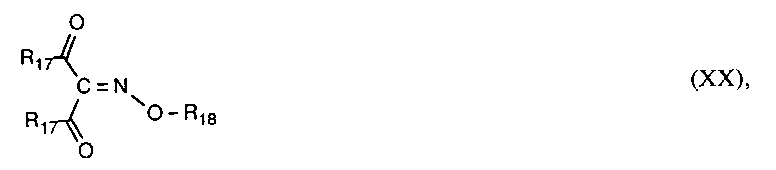 worin die Reste R₁₇ unabhängig voneinander für p-Tolyl, p-Alkoxyphenyl oder Mesityl stehen und R₁₈ C₁-C₆-Alkylcarbonyl, C₁-C₆-Alkoxycarbonyl, C₆-C₁₄-Arylcarbonyl oder C₆-C₁₄-Aryloxycarbonyl bedeutet, und
(c) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

18. Zusammensetzung nach Anspruch 17, enthaltend zusätzlich
(d) ein aromatisches Amin der Formel (XXI) 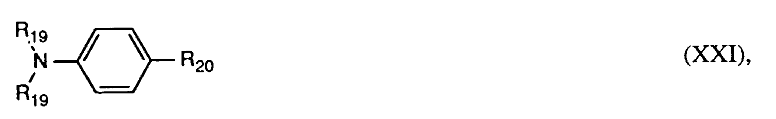 bedeutet, worin die beiden R₁₉ unabhängig voneinander für C₁-C₃-Alkyl oder C₁-C₃-Hydloxyalkyl stehen oder zusammen mit dem N-Atom eine Morpholingruppe bilden und R₂₀ eine C₁-C₃-Alkylgruppe, C₂-C₅-Alkylcarbonylgruppe oder C₇-C₁₀-Arylcarbonylgruppe darstellt

19. Zusammensetzung nach Anspruch 18, enthaltend zusätzlich
(e) ein Cumarin der Formel (XXII) 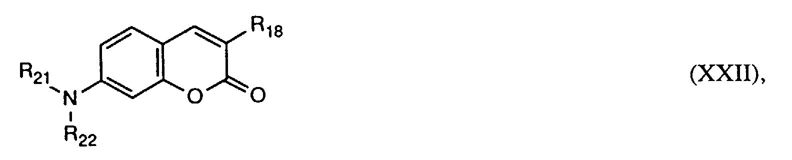 steht, worin R₂₁ und R₂₂ unabhängig voneinander C₁-C₆-Alkylgruppen sind und R₁₈ C₁-C₆-Alkylcarbonyl, C₁-C₆-Alkoxycarbonyl, C₆-C₁₄-Arylcarbonyl oder C₆-C₁₄-Aryloxycarbonyl bedeutet.

20. Zusammensetzung enthaltend
(a) ein Polymer enthaltend wiederkehrende Strukturelemente der Formel (I) gemäss Anspruch 1,
(b) ein Cumarin der Formel (XXIII) 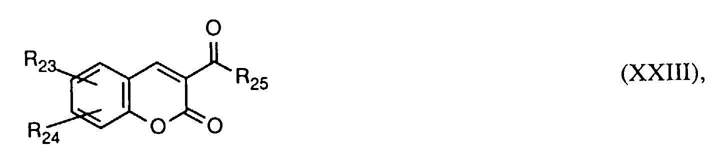 worin R₂₃ und R₂₄ unabhängig voneinander Wasserstoff oder C₁-C₆-Alkoxy bedeuten und R₂₅ für C₆-C₁₄-Aryl oder einen Rest der Formel (XXIV) steht 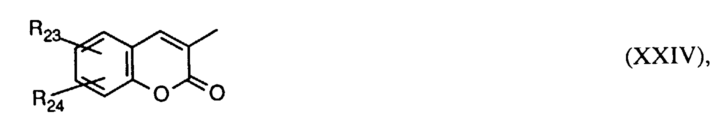 worin R₂₃ und R₂₄ die gleiche Bedeutung wie in Formel (XXIII) haben, und
(c) eine Aminosäure der Formel (XXV) 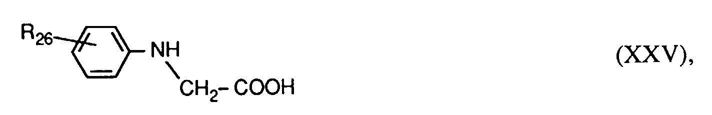 worin R₂₆ für Wasserstoff, Methyl, Ethyl, i-Propyl, t-Butyl, Phenyl, Methoxy, Ethoxy, Hydroxy, Hydroxymethyl, Dimethylamino, Diethylamino, Acetyl, Propionyl, Acetyloxy, Propionyloxy, -NHCONH₂ oder -NHCOOCH₃ steht, und gegebenenfalls
(d) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

21. Zusammensetzung enthaltend
(a) ein Polymer enthaltend wiederkehrende Strukturelemente der Formel (I) gemäss Anspruch 1,
(b) ein Cumarin der Formel (XXIII) gemäss Anspruch 20,
(c) ein Oxazolon der Formel (XXVI) 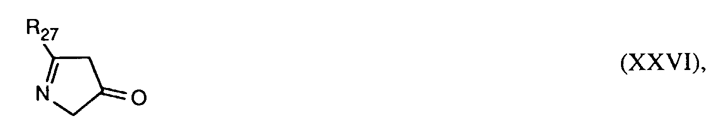 worin R₂₇ für eine Gruppe der Formeln (XXVII) oder (XXVIII) steht 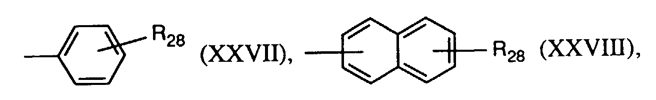 worin R₂₈ Wasserstoff, Methyl, Ethyl, n-Propyl, i-Propyl, n-Butyl, t-Butyl, Phenyl, Hydroxy, Methoxy, Ethoxy, n-Propoxy, n-Butoxy, Phenoxy, Benzyl, 2-Phenylethyl, Hydroxymethyl, 2-Hydroxyethyl, Acetyl, Propionyl, Acetyloxy, Propionyloxy, Aminomethyl, 2-Aminoethyl, Methylamino, Dimethylamino, Diethylamino, -CONH₂, -CONHCH₃, -CON(CH₃)₂, -CONHC₂H₅ oder -CON(C₂H₅)₂ bedeutet, und gegebenenfalls
(d) einen Acryl- oder Methacrylsäureester von aromatischen oder aliphatischen Polyolen, Allylether von aromatischen oder aliphatischen Polyolen oder Allylester von aromatischen oder aliphatischen Polycarbonsäuren.

## Claims (Claims for the following Contracting State(s): BE, CH, LI, NL)

1. Process for the manufacture of relief images, comprising the following steps:
(A) coating a substrate with a photopolymerisable composition comprising a polymer (a) and a photoinitiator (b),
(B) image-wise exposure of the coated substrate with UV radiation in the i-line range (approximately 360-370 nm),
(C) removal of the unexposed areas using a solvent and
(D) tempering the exposed and developed material,
characterised in that a polyimide precursor comprising structural repeating units of formula (I) is used as the polymer (a) 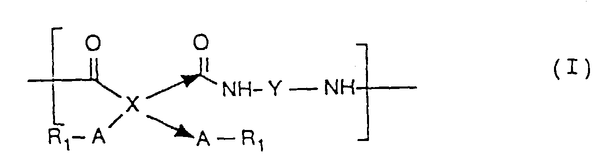 wherein → represents structural isomers, X is the tetravalent radical of an aromatic tetracarboxylic acid, Y is a divalent aliphatic, cycloaliphatic or mono- or poly-nuclear aromatic radical, A is -COO-, -CONH- or -COO^{⊖} HN^{⊕}R₂R₃- wherein R₂ and R₃ are, independently of one another, C₁-C₆alkyl or C₁-C₆alkenyl, and R₁ is a radical having a photopolymerisable olefinic double bond,
with the proviso that at least 50% of all radicals X are oxydiphthalic acid radicals or at least 50% of all radicals Y are radicals of an aromatic diamine that is substituted at all four ortho positions to the two amine nitrogen atoms, independently of one another, by C₁-C₆alkyl, C₁-C₆alkoxy or by C₆-C₁₄aryl.

2. Process according to Claim 1,
characterised in that there is used as the polymer (a) a polyimide precursor comprising structural repeating units of formula (I) wherein at least 50% of all radicals X are oxydiphthalic acid radicals and Y is as defined in Claim 1.

3. Process according to Claim 1,
characterised in that there is used as the polymer (a) a polyimide precursor comprising structural repeating units of formula (I) wherein at least 80% of all radicals X are oxydiphthalic acid radicals.

4. Process according to Claim 1,
characterised in that there is used as the polymer (a) a polyimide precursor comprising structural repeating units of formula (I) wherein 100% of all radicals X are oxydiphthalic acid radicals.

5. Process according to Claim 1,
characterised in that there is used as the polymer (a) a polyimide precursor comprising structural repeating units of formula (I) wherein A is -COO- and R₁ is vinyl, allyl, methallyl or a radical of formula (II) 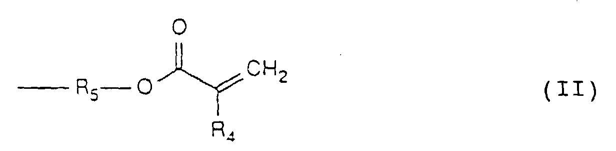 wherein R₄ is hydrogen or methyl and R₅ is -CₙH₂ₙ- with n = 2-12, -CH₂CH(OH)CH₂- or polyoxyalkylene having from 4 to 30 carbon atoms.

6. Process according to Claim 2,
characterised in that there is used as the polymer (a) a polyimide precursor comprising structural repeating units of formula (I) wherein Y is a radical of formulae (III)-(V) that is unsubstituted or substituted by one or more C₁-C₆-alkyl groups or C₁-C₆alkoxy groups 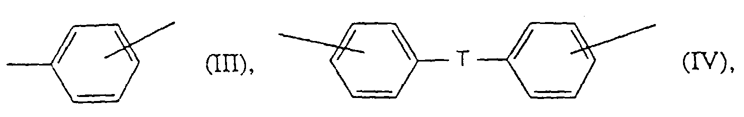 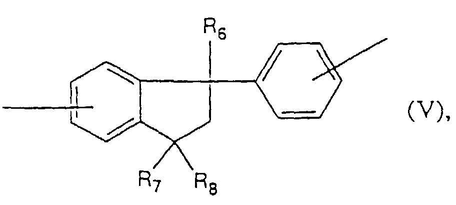 wherein T is a direct bond, -CH₂-, C₂-C₁₂alkylidene, -C(CF₃)₂-, -NH-, -S-, -O-, -SO-, -SO₂- or -CO- and R₆, R₇ and R₈ are, independently of one another, hydrogen or C₁-C₆alkyl.

7. Process according to Claim 2,
characterised in that there is used as the polymer (a) a polyimide precursor comprising structural repeating units of formula (I) wherein Y is a radical of formulae (VI)-(VIII)

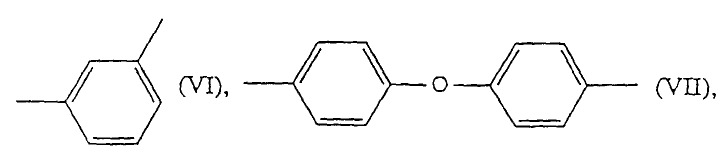

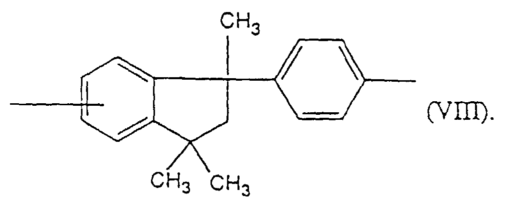

8. Process according to Claim 1,
characterised in that there is used as the polymer (a) a polyimide precursor comprising structural repeating units of formula (I) wherein at least 50% of all radicals Y are radicals of an aromatic diamine that is substituted at all four ortho positions to the two amine nitrogen atoms, independently of one another, by C₁-C₆alkyl, C₁-C₆alkoxy or by C₆-C₁₄aryl, and X is as defined in Claim 1.

9. Process according to Claim 1,
characterised in that there is used as the polymer (a) a polyimide precursor comprising structural repeating units of formula (I) wherein at least 80% of all radicals Y are radicals of an aromatic diamine that is substituted at all four ortho positions to the two amine nitrogen atoms, independently of one another, by C₁-C₆alkyl, C₁-C₆alkoxy or by C₆-C₁₄aryl.

10. Process according to Claim 1,
characterised in that there is used as the polymer (a) a polyimide precursor comprising structural repeating units of formula (I) wherein 100% of radicals Y are radicals of an aromatic diamine that is substituted at all four ortho positions to the two amine nitrogen atoms, independently of one another, by C₁-C₆alkyl, C₁-C₆alkoxy or by C₆-C₁₄-aryl.

11. Process according to Claim 8,
characterised in that there is used as the polymer (a) a polyimide precursor comprising structural repeating units of formula (I) wherein Y is a radical of formula (IX), (X) or (XI) 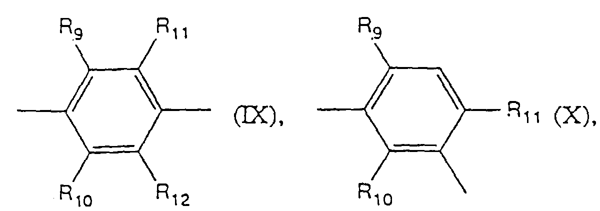 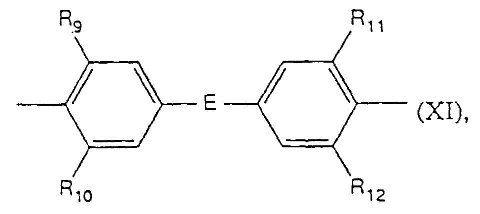 wherein R₉, R₁₀, R₁₁ and R₁₂ are, independently of one another, C₁-C₆alkyl and E is a direct bond, -CH₂-, C₂-C₁₂alkylidene, -C(CF₃)₂-, -NH-, -S-, -O-, -SO-, -SO₂- or -CO-.

12. Process according to Claim 8,
characterised in that there is used as the polymer (a) a polyimide precursor comprising structural repeating units of formula (I) wherein Y represents

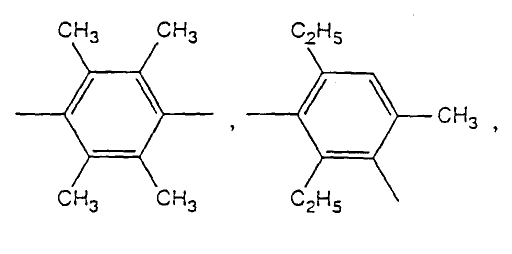

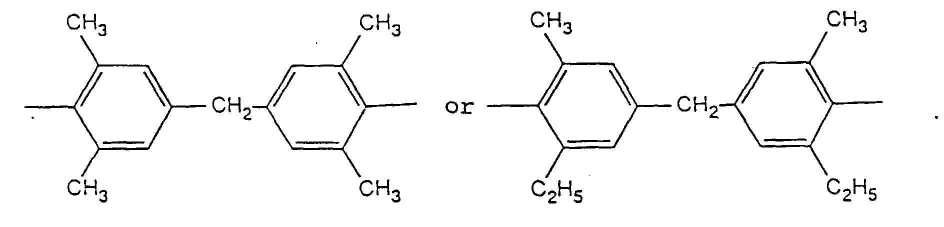

13. Process according to Claim 8,
characterised in that there is used as the polymer (a) a polyimide precursor comprising structural repeating units of formula (I) wherein X is the radical of pyromellitic acid, 3,3',4,4'-biphenyltetracarboxylic acid, oxydiphthalic acid, 3,3',4,4'-benzophenonetetracarboxylic acid or of hexafluoroisopropylidenediphthalic acid.

14. Composition comprising
(a) a polymer comprising structural repeating units of formula (I) according to Claim 1, and
(b) a titanocene of formula (XIV) 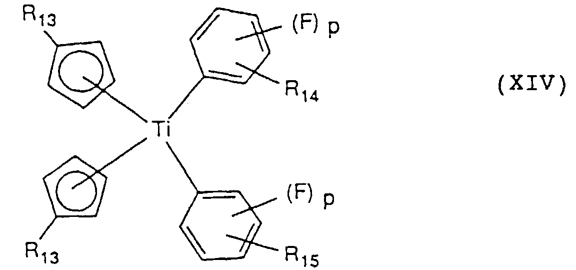 wherein the two radicals R₁₃ are, independently of one another, hydrogen or C₁-C₆alkyl, R₁₄ and R₁₅ are C₁-C₆alkyl, C₆-C₁₄aryl or a heterocyclic five- or six-membered aliphatic or aromatic ring and p is a number from 2 to 5, with the proviso that in each case two fluorine atoms occupy the ortho positions of the two phenyl rings.

15. Composition according to Claim 14,
comprising as the component (b) a titanocene of formulae (XV)-(XVIII)

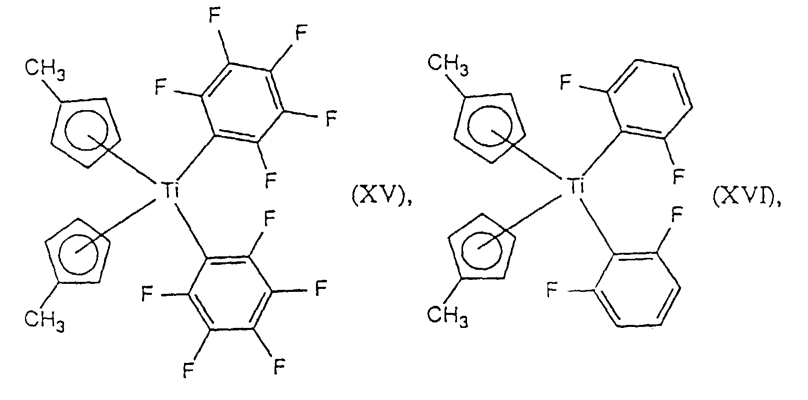

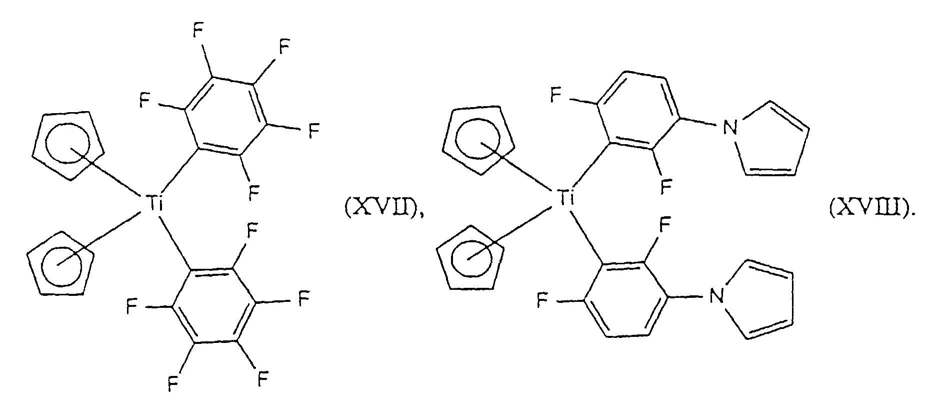

16. Composition according to Claim 14, additionally comprising
(c) an acrylic or methacrylic acid ester of aromatic or aliphatic polyols, allyl ethers of aromatic or aliphatic polyols or allyl esters of aromatic or aliphatic polycarboxylic acids.

17. Composition comprising
(a) a polymer comprising structural repeating units of formula (I) according to Claim 1,
(b) a triketone oxime ester of formula (XX) 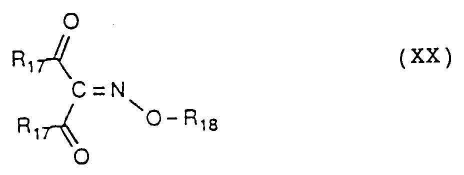 wherein the radicals R₁₇ are, independently of one another, p-tolyl, p-alkoxyphenyl or mesityl and R₁₈ is C₁-C₆alkylcarbonyl, C₁-C₆alkoxycarbonyl, C₆-C₁₄arylcarbonyl or C₆-C₁₄aryloxycarbonyl, and
(c) an acrylic or methacrylic acid ester of aromatic or aliphatic polyols, allyl ethers of aromatic or aliphatic polyols or allyl esters of aromatic or aliphatic polycarboxylic acids.

18. Composition according to Claim 17, additionally comprising
(d) an aromatic amine of formula (XXI) 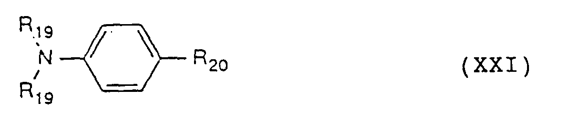 wherein the two radicals R₁₉ are, independently of one another, C₁-C₃alkyl or C₁-C₃hydroxyalkyl or, together with the nitrogen atom, form a morpholine group, and R₂₀ is a C₁-C₃alkyl group, a C₂-C₅alkylcarbonyl group or a C₇-C₁₀arylcarbonyl group.

19. Composition according to Claim 18, additionally comprising
(e) a coumarin of formula (XXII) 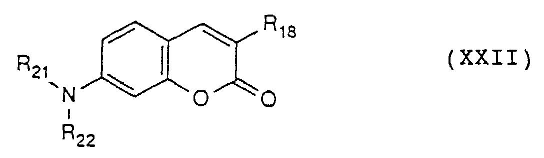 wherein R₂₁ and R₂₂ are, independently of one another, C₁-C₆alkyl groups and R₁₈ is C₁-C₆alkylcarbonyl, C₁-C₆alkoxycarbonyl, C₆-C₁₄arylcarbonyl or C₆-C₁₄aryloxycarbonyl.

20. Composition comprising
(a) a polymer comprising structural repeating units of formula (I) according to Claim 1,
(b) a coumarin of formula (XXIII) 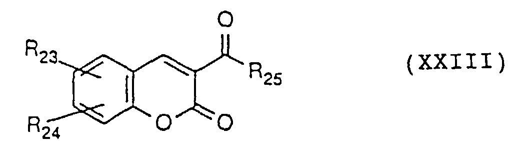 wherein R₂₃ and R₂₄ are, independently of one another, hydrogen or C₁-C₆alkoxy, and R₂₅ is C₆-C₁₄aryl or a radical of formula (XXIV) 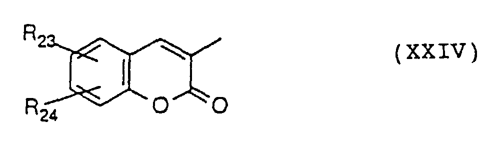 wherein R₂₃ and R₂₄ are as defined in formula (XXIII) and
(c) an amino acid of formula (XXV) 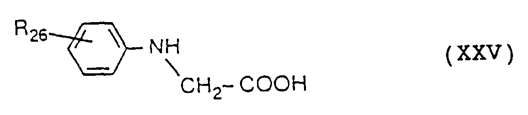 wherein R₂₆ is hydrogen, methyl, ethyl, i-propyl, t-butyl, phenyl, methoxy, ethoxy, hydroxy, hydroxymethyl, dimethylamino, diethylamino, acetyl, propionyl, acetyloxy, propionyloxy, -NHCONH₂ or -NHCOOCH₃ and, where appropriate,
(d) an acrylic or methacrylic acid ester of aromatic or aliphatic polyols, allyl ethers of aromatic or aliphatic polyols or allyl esters of aromatic or aliphatic polycarboxylic acids.

21. Composition comprising
(a) a polymer comprising structural repeating units of formula (I) according to Claim 1,
(b) a coumarin of formula (XXIII) according to Claim 20,
(c) an oxazolone of formula (XXVI) 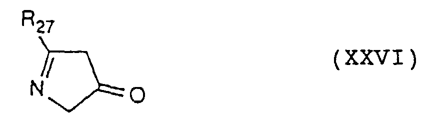 wherein R₂₇ is a group of formula (XXVII) or (XXVIII) 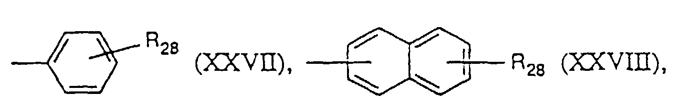 wherein R₂₈ is hydrogen, methyl, ethyl, n-propyl, i-propyl, n-butyl, t-butyl, phenyl, hydroxy, methoxy, ethoxy, n-propoxy, n-butoxy, phenoxy, benzyl, 2-phenylethyl, hydroxymethyl, 2-hydroxyethyl, acetyl, propionyl, acetyloxy, propionyloxy, aminomethyl, 2-aminoethyl, methylamino, dimethylamino, diethylamino, -CONH₂, -CONHCH₃, -CON(CH₃)₂, -CONHC₂H₅ or -CON(C₂H₅)₂ and, where appropriate,
(d) an acrylic or methacrylic acid ester of aromatic or aliphatic polyols, allyl ethers of aromatic or aliphatic polyols or allyl esters of aromatic or aliphatic polycarboxylic acids.

## Claims (Claims for the following Contracting State(s): DE, FR, GB, IT)

1. Process for the manufacture of relief images, comprising the following steps:
(A) coating a substrate with a photopolymerisable composition comprising a polymer (a) and a photoinitiator (b),
(B) image-wise exposure of the coated substrate with UV radiation in the i-line range (approximately 360-370 nm),
(C) removal of the unexposed areas using a solvent and
(D) tempering the exposed and developed material,
wherein a polyimide precursor comprising structural repeating units of formula (I) is used as the polymer (a) 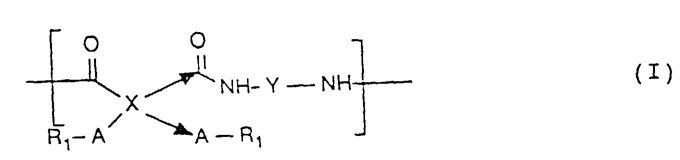 wherein → represents structural isomers, X is the tetravalent radical of an aromatic tetracarboxylic acid, y is a divalent aliphatic, cycloaliphatic or mono- or poly-nuclear aromatic radical, A is -COO-, -CONH- or -COO^{⊖}HN^{⊕}R₂R₃- wherein R₂ and R₃ are, independently of one another, C₁-C₆alkyl or C₁-C₆alkenyl, and R₁ is a radical having a photopolymerisable olefinic double bond,
with the proviso that at least 50% of all radicals X are oxydiphthalic acid radicals or at least 50% of all radicals Y are radicals of an aromatic diamine that is substituted at all four ortho positions to the two amine nitrogen atoms, independently of one another, by C₁-C₆alkyl, C₁-C₆alkoxy or by C₆-C₁₄aryl,
and wherein a titanocene of formula (XIV) or a coumarin of formula (XXIII) is used as component (b) 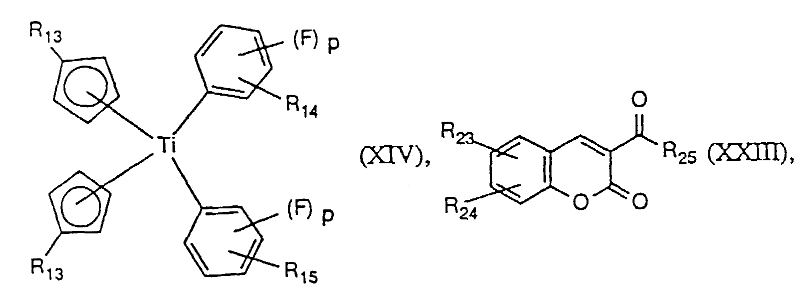 wherein the two radicals R₁₃ are, independently of one another, hydrogen or C₁-C₆alkyl, R₁₄ and R₁₅ are C₁-C₆alkyl, C₆-C₁₄aryl or a heterocyclic five- or six-membered aliphatic or aromatic ring and p is a number from 2 to 5, with the proviso that in each case two fluorine atoms occupy the ortho positions of the two phenyl rings;
wherein R₂₃ and R₂₄ are, independently of one another, hydrogen or C₁-C₆alkoxy, and R₂₅ is C₆-C₁₄aryl or a radical of formula (XXIV) 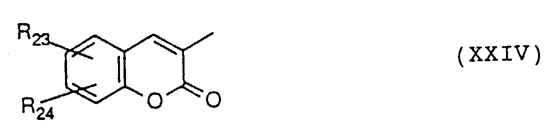 wherein R₂₃ and R₂₄ are as defined in formula (XXIII).

2. Process according to Claim 1,
characterised in that there is used as the polymer (a) a polyimide precursor comprising structural repeating units of formula (I) wherein at least 50% of all radicals X are oxydiphthalic acid radicals and Y is as defined in Claim 1.

3. Process according to Claim 1,
characterised in that there is used as the polymer (a) a polyimide precursor comprising structural repeating units of formula (I) wherein at least 80% of all radicals X are oxydiphthalic acid radicals.

4. Process according to Claim 1,
characterised in that there is used as the polymer (a) a polyimide precursor comprising structural repeating units of formula (I) wherein 100% of all radicals X are oxydiphthalic acid radicals.

5. Process according to Claim 1,
characterised in that there is used as the polymer (a) a polyimide precursor comprising structural repeating units of formula (I) wherein A is -COO- and R₁ is vinyl, allyl, methallyl or a radical of formula (II) 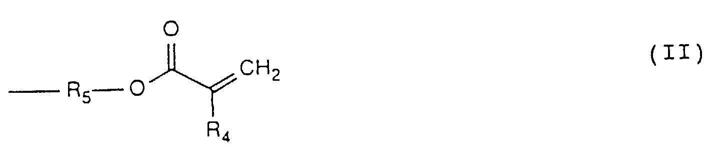 wherein R₄ is hydrogen or methyl and R₅ is -CₙH₂ₙ- with n = 2-12, -CH₂CH(OH)CH₂- or polyoxyalkylene having from 4 to 30 carbon atoms.

6. Process according to Claim 2,
characterised in that there is used as the polymer (a) a polyimide precursor comprising structural repeating units of formula (I) wherein Y is a radical of formulae (III)-(V) that is unsubstituted or substituted by one or more C₁-C₆-alkyl groups or C₁-C₆alkoxy groups 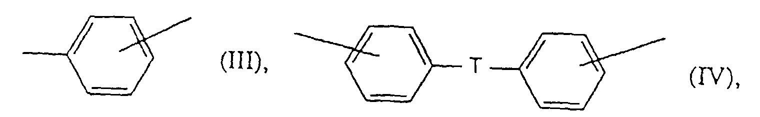 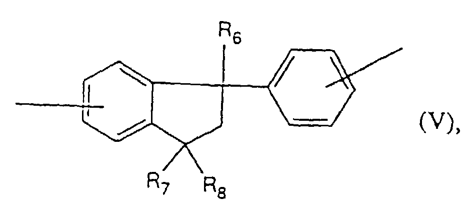 wherein T is a direct bond, -CH₂-, C₂-C₁₂alkylidene, -C(CF₃)₂-, -NH-, -S-, -O-, -SO-, -SO₂- or -CO- and R₆, R₇ and R₈ are, independently of one another, hydrogen or C₁-C₆alkyl.

7. Process according to Claim 2,
characterised in that there is used as the polymer (a) a polyimide precursor comprising structural repeating units of formula (I) wherein Y is a radical of formulae (VI)-(VIII)

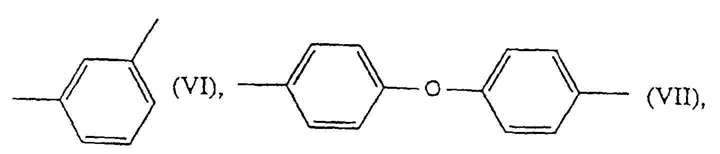

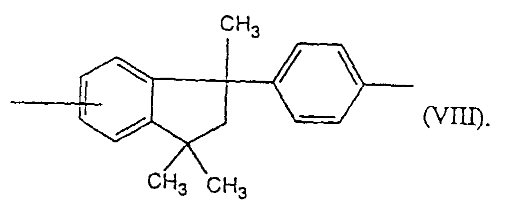

8. Process according to Claim 1,
characterised in that there is used as the polymer (a) a polyimide precursor comprising structural repeating units of formula (I) wherein at least 50% of all radicals Y are radicals of an aromatic diamine that is substituted at all four ortho positions to the two amine nitrogen atoms, independently of one another, by C₁-C₆alkyl, C₁-C₆alkoxy or by C₆-C₁₄aryl, and X is as defined in Claim 1.

9. Process according to Claim 1,
characterised in that there is used as the polymer (a) a polyimide precursor comprising structural repeating units of formula (I) wherein at least 80% of all radicals Y are radicals of an aromatic diamine that is substituted at all four ortho positions to the two amine nitrogen atoms, independently of one another, by C₁-C₆alkyl, C₁-C₆alkoxy or by C₆-C₁₄aryl.

10. Process according to Claim 1,
characterised in that there is used as the polymer (a) a polyimide precursor comprising structural repeating units of formula (I) wherein 100% of radicals Y are radicals of an aromatic diamine that is substituted at all four ortho positions to the two amine nitrogen atoms, independently of one another, by C₁-C₆alkyl, C₁-C₆alkoxy or by C₆-C₁₄-aryl.

11. Process according to Claim 8,
characterised in that there is used as the polymer (a) a polyimide precursor comprising structural repeating units of formula (I) wherein Y is a radical of formula (IX), (X) or (XI) 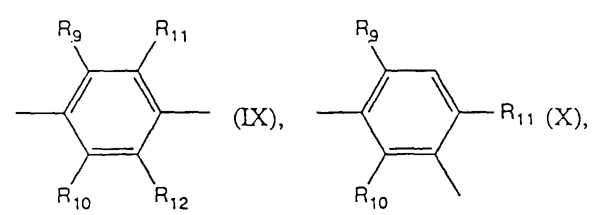 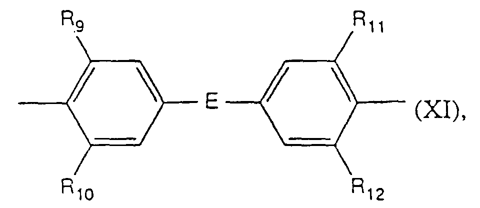 wherein R₉, R₁₀, R₁₁ and R₁₂ are, independently of one another, C₁-C₆alkyl and E is a direct bond, -CH₂-, C₂-C₁₂alkylidene, -C(CF₃)₂-, -NH-, -S-, -O-, -SO-, -SO₂- or -CO-.

12. Process according to Claim 8,
characterised in that there is used as the polymer (a) a polyimide precursor comprising structural repeating units of formula (I) wherein Y represents

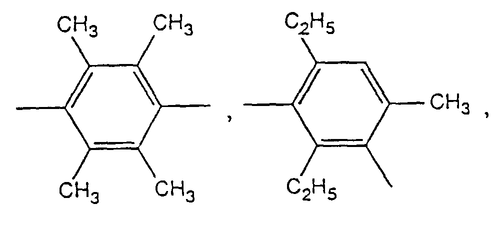

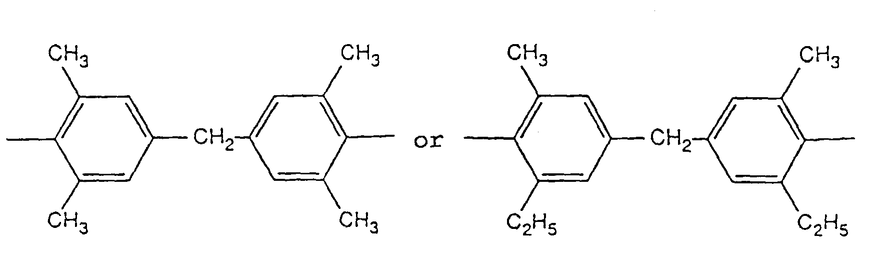

13. Process according to Claim 8,
characterised in that there is used as the polymer (a) a polyimide precursor comprising structural repeating units of formula (I) wherein X is the radical of pyromellitic acid, 3,3',4,4'-biphenyltetracarboxylic acid, oxydiphthalic acid, 3,3',4,4'-benzophenonetetracarboxylic acid or of hexafluoroisopropylidenediphthalic acid.

14. Composition comprising
(a) a polymer comprising structural repeating units of formula (I) according to Claim 1, and
(b) a titanocene of formula (XIV) 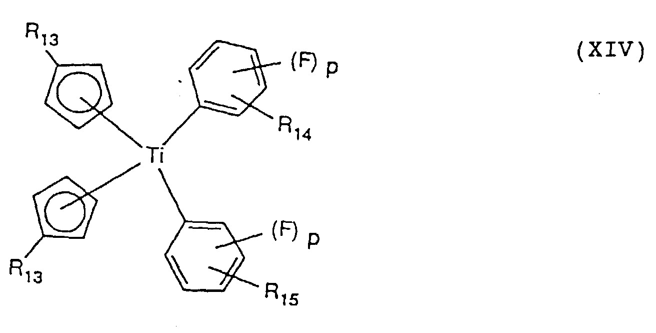 wherein the two radicals R₁₃ are, independently of one another, hydrogen or C₁-C₆alkyl, R₁₄ and R₁₅ are C₁-C₆alkyl, C₆-C₁₄aryl or a heterocyclic five- or six-membered aliphatic or aromatic ring and p is a number from 2 to 5, with the proviso that in each case two fluorine atoms occupy the ortho positions of the two phenyl rings.

15. Composition according to Claim 14,
comprising as the component (b) a titanocene of formulae (XV)-(XVIII)

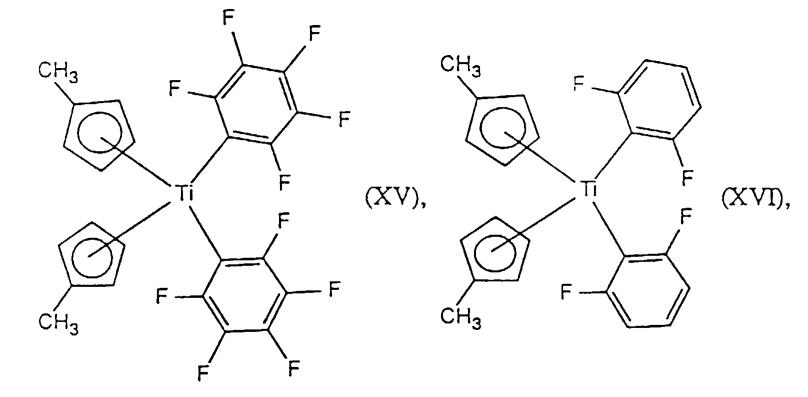

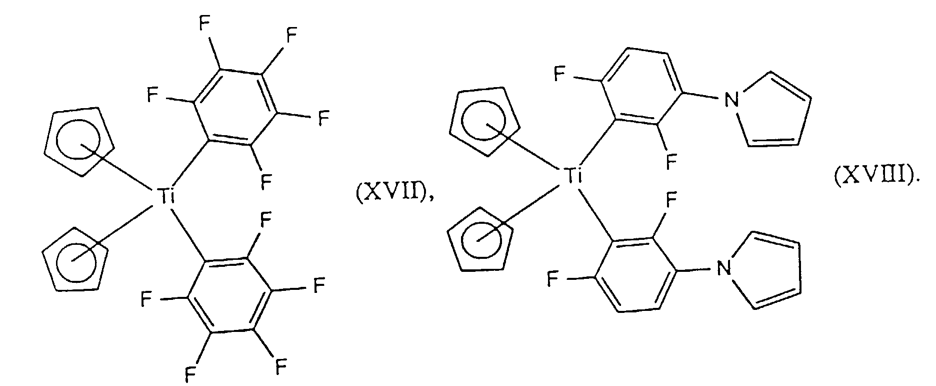

16. Composition according to Claim 14, additionally comprising
(c) an acrylic or methacrylic acid ester of aromatic or aliphatic polyols, allyl ethers of aromatic or aliphatic polyols or allyl esters of aromatic or aliphatic polycarboxylic acids.

17. Composition comprising
(a) a polymer comprising structural repeating units of formula (I) according to Claim 1,
(b) a triketone oxime ester of formula (XX) 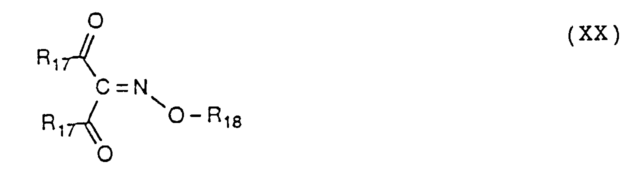 wherein the radicals R₁₇ are, independently of one another, p-tolyl, p-alkoxyphenyl or mesityl and R₁₈ is C₁-C₆alkylcarbonyl, C₁-C₆alkoxycarbonyl, C₆-C₁₄arylcarbonyl or C₆-C₁₄aryloxycarbonyl, and
(c) an acrylic or methacrylic acid ester of aromatic or aliphatic polyols, allyl ethers of aromatic or aliphatic polyols or allyl esters of aromatic or aliphatic polycarboxylic acids.

18. Composition according to Claim 17, additionally comprising
(d) an aromatic amine of formula (XXI) 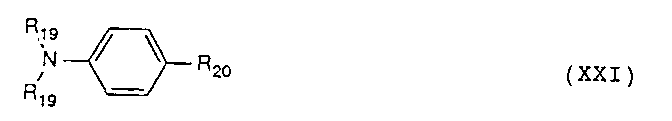 wherein the two radicals R₁₉ are, independently of one another, C₁-C₃alkyl or C₁-C₃hydroxyalkyl or, together with the nitrogen atom, form a morpholine group, and R₂₀ is a C₁-C₃alkyl group, a C₂-C₅alkylcarbonyl group or a C₇-C₁₀arylcarbonyl group.

19. Composition according to Claim 18, additionally comprising
(e) a coumarin of formula (XXII) 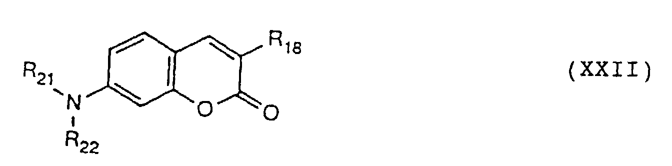 wherein R₂₁ and R₂₂ are, independently of one another, C₁-C₆alkyl groups and R₁₈ is C₁-C₆alkylcarbonyl, C₁-C₆alkoxycarbonyl, C₆-C₁₄arylcarbonyl or C₆-C₁₄aryloxycarbonyl.

20. Composition comprising
(a) a polymer comprising structural repeating units of formula (I) according to Claim 1,
(b) a coumarin of formula (XXIII) 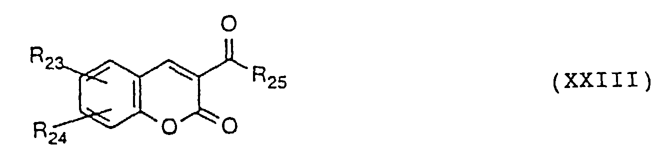 wherein R₂₃ and R₂₄ are, independently of one another, hydrogen or C₁-C₆alkoxy, and R₂₅ is C₆-C₁₄aryl or a radical of formula (XXIV) 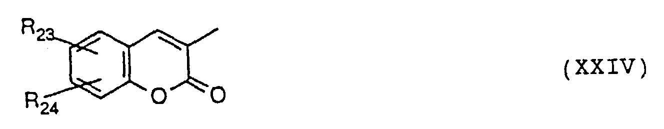 wherein R₂₃ and R₂₄ are as defined in formula (XXIII) and
(c) an amino acid of formula (XXV) 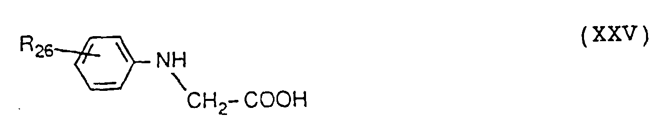 wherein R₂₆ is hydrogen, methyl, ethyl, i-propyl, t-butyl, phenyl, methoxy, ethoxy, hydroxy, hydroxymethyl, dimethylamino, diethylamino, acetyl, propionyl, acetyloxy, propionyloxy, -NHCONH₂ or -NHCOOCH₃ and, where appropriate,
(d) an acrylic or methacrylic acid ester of aromatic or aliphatic polyols, allyl ethers of aromatic or aliphatic polyols or allyl esters of aromatic or aliphatic polycarboxylic acids.

21. Composition comprising
(a) a polymer comprising structural repeating units of formula (I) according to Claim 1,
(b) a coumarin of formula (XXIII) according to Claim 20,
(c) an oxazolone of formula (XXVI) 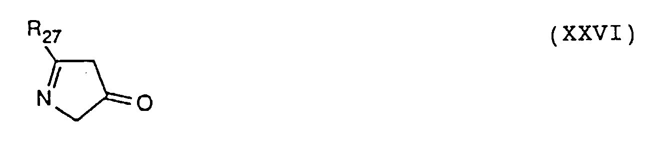 wherein R₂₇ is a group of formula (XXVII) or (XXVIII) 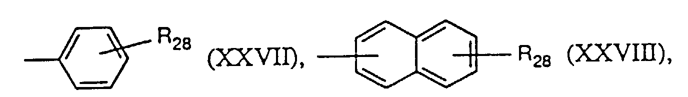 wherein R₂₈ is hydrogen, methyl, ethyl, n-propyl, i-propyl, n-butyl, t-butyl, phenyl, hydroxy, methoxy, ethoxy, n-propoxy, n-butoxy, phenoxy, benzyl, 2-phenylethyl, hydroxymethyl, 2-hydroxyethyl, acetyl, propionyl, acetyloxy, propionyloxy, aminomethyl, 2-aminoethyl, methylamino, dimethylamino, diethylamino, -CONH₂, -CONHCH₃, -CON(CH₃)₂, -CONHC₂H₅ or -CON(C₂H₅)₂ and, where appropriate,
(d) an acrylic or methacrylic acid ester of aromatic or aliphatic polyols, allyl ethers of aromatic or aliphatic polyols or allyl esters of aromatic or aliphatic polycarboxylic acids.

## Revendications (Revendications pour l'(les) Etat(s) contractant(s) suivant(s): BE, CH, LI, NL)

1. Procédé pour la préparation d'images en relief, comprenant les étapes suivantes :
(A) revêtement d'un substrat avec une composition photopolymérisable contenant un polymère (a) et un photoinitiateur (b),
(B) irradiation aux dimensions de l'image du substrat revêtu avec un rayonnement UV dans le domaine de la bande i (environ 360-370nm),
(C) élimination des endroits non irradiés à l'aide d'un solvant et
(D) recuisson du matériau irradié et développé,
caractérisé en ce que l'on utilise comme polymère (a) un progéniteur de polyimide contenant des éléments structurels répétitifs de la formule (I), 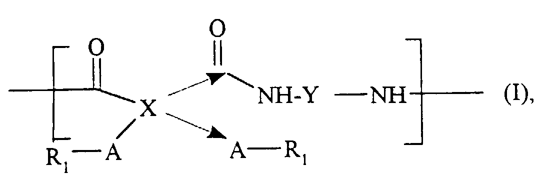 où → représente les isomères de structure, X représente le reste tétravalent d'un acide aromatique tétracarboxylique, Y est un reste bivalent aliphatique, cycloaliphatique ou aromatique mono- ou polycyclique, A est -COO-, -CONH- ou -COO^{⊖}HN^{⊕}R₂R₃-, où R₂ et R₃ représentent indépendamment un groupe alkyle en C₁-C₆ ou alcényle en C₁-C₆, et R₁ est un reste avec une double liaison oléfinique photopolymérisable,
avec les proportions qu'au moins 50% de tous les restes X représentent le reste de l'acide oxydiphtalique ou qu'au moins 50% de tous les restes Y représentent un reste d'une diamine aromatique, qui est substituée à toutes les quatre positions ortho vers les deux atomes d'azote de l'amine indépendamment par un groupe alkyle en C₁-C₆, alcoxy en C₁-C₆ ou aryle en C₆-C₁₄.

2. Procédé selon la revendication 1, caractérisé en ce que l'on utilise comme polymère (a) un progéniteur de polyimide contenant des éléments structurels répétitifs de la formule (I), où au moins 50% de tous les restes X représentent le reste de l'acide oxydiphtalique et Y a la même signification que dans la revendication 1.

3. Procédé selon la revendication 1, caractérisé en ce que l'on utilise comme polymère (a) un progéniteur de polyimide contenant des éléments structurels répétitifs de la formule (I), où au moins 80% de tous les restes X représentent le reste de l'acide oxydiphtalique.

4. Procédé selon la revendication 1, caractérisé en ce que l'on utilise comme polymère (a) un progéniteur de polyimide contenant des éléments structurels répétitifs de la formule (I), où 100% de tous les restes X représentent le reste de l'acide oxydiphtalique.

5. Procédé selon la revendication 1, caractérisé en ce que l'on utilise comme polymère (a) un progéniteur de polyimide contenant des éléments structurels répétitifs de la formule (I), où A est -COO- et R₁ est un groupe vinyle, allyle, méthallyle ou un reste de la formule (II) 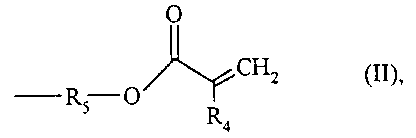 où R₄ est l'hydrogène ou un groupe méthyle et R₅ est -CₙH₂ₙ- avec n = 2-12, -CH₂CH(OH)CH₂- ou un polyoxyalkylène avec 4-30 atomes de carbone.

6. Procédé selon la revendication 2, caractérisé en ce que l'on utilise comme polymère (a) un progéniteur de polyimide contenant des éléments structurels répétitifs de la formule (I), où Y est un reste des formules (III)-(V) 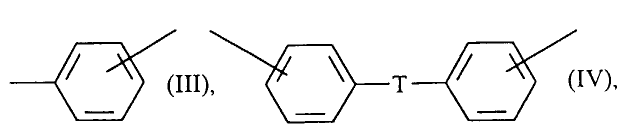 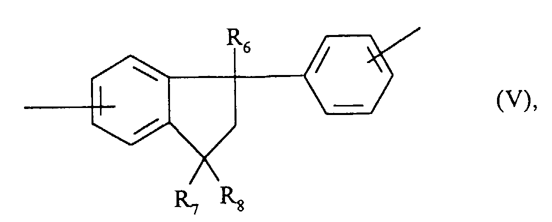 non substitué ou substitué par un ou plusieurs groupes alkyle en C₁-C₆ ou groupes alcoxy en C₁-C₆,où T est une liaison directe, -CH₂-, un groupe alkylidène en C₂-C₁₂, -C(CF₃)₂-, -NH-, -S-, -O-, -SO-, -SO₂- ou -CO- et R₆, R₇ et R₈ sont indépendamment l'hydrogène ou un groupe alkyle en C₁-C₆.

7. Procédé selon la revendication 2, caractérisé en ce que l'on utilise comme polymère (a) un progéniteur de polyimide contenant des éléments structurels répétitifs de la formule (I), où Y est un reste des formules (VI)-(VIII)

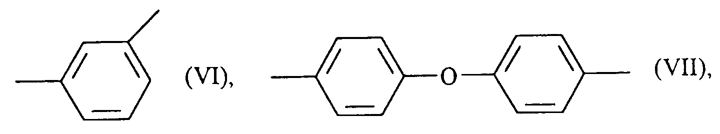

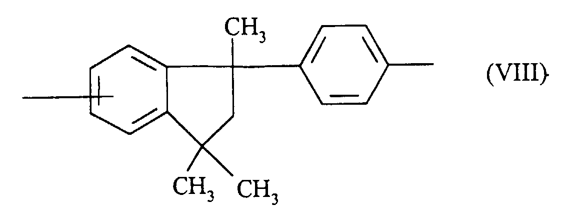

8. Procédé selon la revendication 1, caractérisé en ce que l'on utilise comme polymère (a) un progéniteur de polyimide contenant des éléments structurels répétitifs de la formule (I), où au moins 50% de tous les restes Y représentent un reste d'une diamine aromatique, qui est substituée toutes les quatre positions ortho vers les deux atomes d'azote de l'amine indépendamment par un groupe alkyle en C₁-C₆, alcoxy en C₁-C₆ ou aryle en C₆-C₁₄, et X a la même signification que dans la revendication 1.

9. Procédé selon la revendication 1, caractérisé en ce que l'on utilise comme polymère (a) un progéniteur de polyimide contenant des éléments structurels répétitifs de la formule (I), où au moins 80% de tous les restes Y représentent un reste d'une diamine aromatique, qui est substituée à toutes les quatre positions ortho vers les deux atomes d'azote de l'amine indépendamment par un groupe alkyle en C₁-C₆, alcoxy en C₁-C₆ ou aryle en C₆-C₁₄.

10. Procédé selon la revendication 1, caractérisé en ce que l'on utilise comme polymère (a) un progéniteur de polyimide contenant des éléments structurels répétitifs de la formule (I), où 100% des restes Y représentent un reste d'une diamine aromatique, qui est substituée à toutes les quatre positions ortho vers les deux atomes d'azote de l'amine indépendamment par un groupe alkyle en C₁-C₆, alcoxy en C₁-C₆ ou aryle en C₆-C₁₄.

11. Procédé selon la revendication 8, caractérisé en ce que l'on utilise comme polymère (a) un progéniteur de polyimide contenant des éléments structurels répétitifs de la formule (I), où Y est un reste des formules (IX), (X) ou (XI) 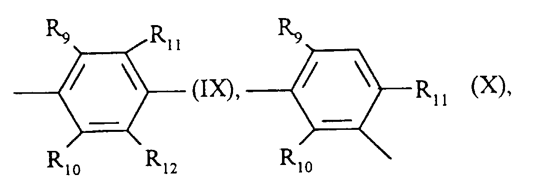 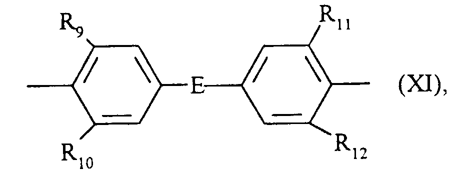 où R₉, R₁₀, R₁₁ et R₁₂ sont indépendamment un groupe alkyle en C₁-C₆ et E est une liaison directe, -CH₂-, un groupe alkylidène en C₂-C₁₂, -C(CF₃)₂-, -NH-, -S-, -O-, -SO, -SO₂- ou -CO-.

12. Procédé selon la revendication 8, caractérisé en ce que l'on utilise comme polymère (a) un progéniteur de polyimide contenant des éléments structurels répétitifs de la formule (I), où Y est

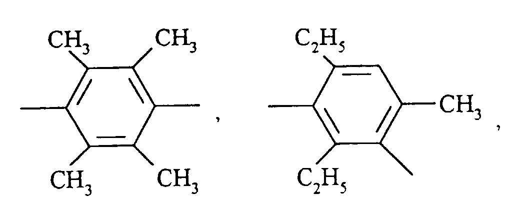

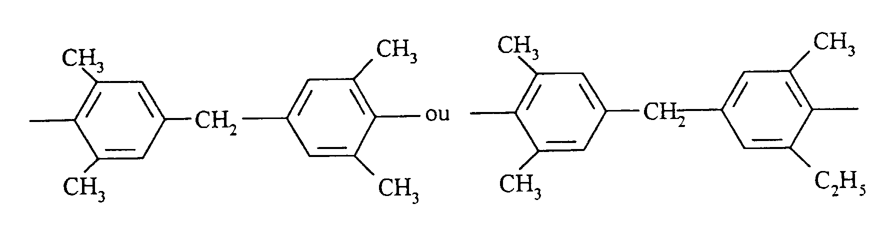

13. Procédé selon la revendication 8, caractérisé en ce que l'on utilise comme polymère (a) un progéniteur de polyimide contenant des éléments structurels répétitifs de la formule (I), où X est le reste de l'acide pyroméllitique, de l'acide 3,3',4,4'-biphényltétracarboxylique, de l'acide oxydiphtalique, de l'acide 3,3',4,4'-benzophénonetétracarboxylique ou de l'acide hexafluoroisopropylidènediphtalique.

14. Composition contenant
(a) un polymère contenant des éléments structurels répétitifs de la formule (I) selon la revendication 1, et
(b) un titanocène de la formule (XIV) 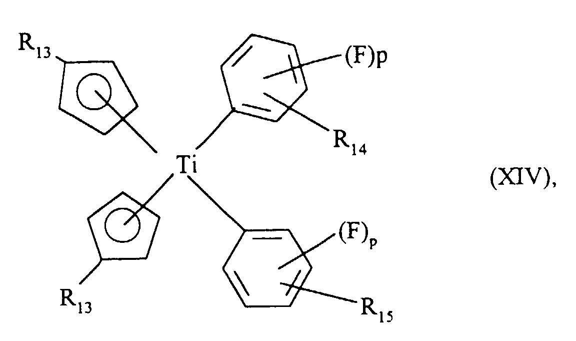 où les deux restes R₁₃ sont indépendamment l'hydrogène ou un groupe alkyle en C₁-C₆, R₁₄ et R₁₅ sont un groupe alkyle en C₁-C₆, aryle en C₆-C₁₄ ou un cycle hétérocyclique aliphatique pentagonal ou hexagonal ou aromatique et p est un nombre de 2 à 5, avec les proportions qu'à chaque fois deux atomes de fluor occupent les positions ortho des deux cycles phényle.

15. Composition selon la revendication 14 contenant comme constituant (b) un titanocène des formules (XV)-(XVIII)

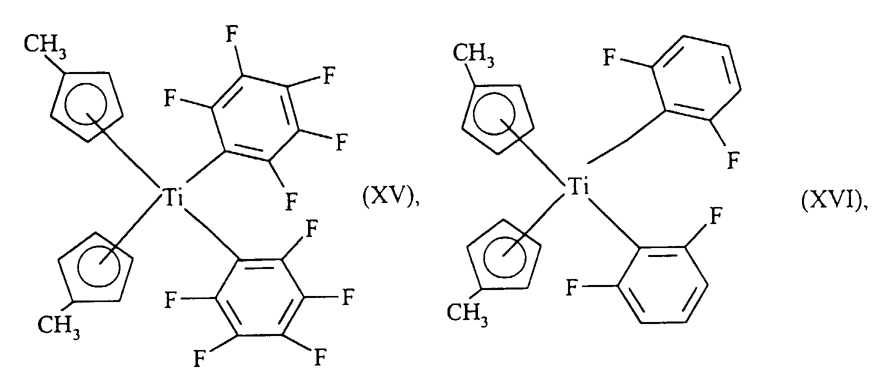

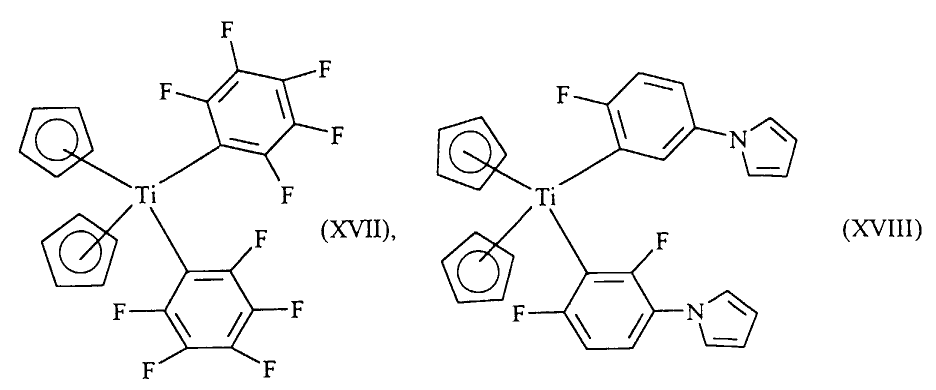

16. Composition selon la revendication 14, contenant en outre
(c) un ester d'acide acrylique ou méthacrylique de polyols aromatiques ou aliphatiques, un allyléther de polyols aromatiques ou aliphatiques ou un ester allylique d'acides polycarboxyliques aromatiques ou aliphatiques.

17. Composition contenant
(a) un polymère contenant des éléments structurels répétitifs de la formule (I) selon la revendication 1,
(b) un ester de tricétoxime de la formule (XX) 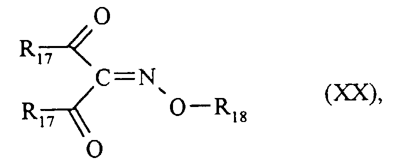 où les restes R₁₇ sont indépendamment un groupe p-tolyle, p-alcoxyphényle ou mésityle et R₁₈ est un groupe alkylcarbonyle en C₁-C₆, alcoxycarbonyle en C₁-C₆, arylcarbonyle en C₆-C₁₄ ou aryloxycarbonyle en C₆-C₁₄, et
(c) un ester d'acide acrylique ou méthacrylique de polyols aromatiques ou aliphatiques, un allyléther de polyols aromatiques ou aliphatiques ou un ester allylique d'acides polycarboxyliques aromatiques ou aliphatiques.

18. Composition selon la revendication 17, contenant en outre
(d) une amine aromatique de la formule (XXI) 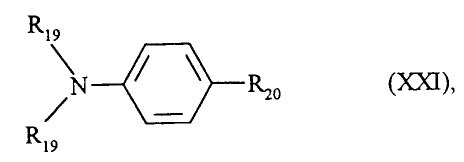 où les deux R₁₉ sont indépendamment un groupe alkyle en C₁-C₃ ou hydroxyalkyle en C₁-C₃ ou forment ensemble avec l'atome N un groupe morpholine et R₂₀ représente un groupe alkyle en C₁-C₃, alkylcarbonyle en C₂-C₅ ou arylcarbonyle en C₇-C₁₀.

19. Composition selon la revendication 18, contenant en outre
(e) une coumarine de la formule (XXII) 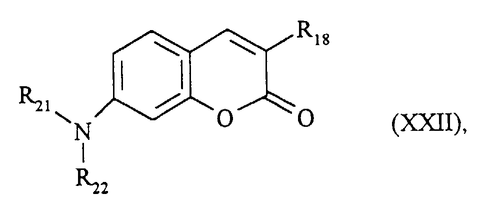 où R₂₁ et R₂₂ sont indépendamment des groupes alkyle en C₁-C₆ et R₁₈ est un groupe alkylcarbonyle en C₁-C₆, alcoxycarbonyle en C₁-C₆, arylcarbonyle en C₆-C₁₄ ou aryloxycarbonyle en C₆-C₁₄.

20. Composition contenant
(a) un polymère contenant des éléments structurels répétitifs de la formule (I) selon la revendication 1,
(b) une coumarine de la formule (XXIII) 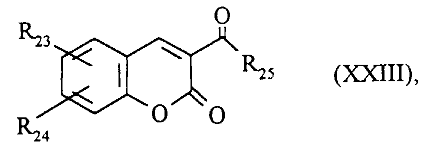 où R₂₃ et R₂₄ sont indépendamment l'hydrogène ou un groupe alcoxy en C₁-C₆ et R₂₅ est un groupe aryle en C₆-C₁₄ ou un reste de la formule (XXIV) 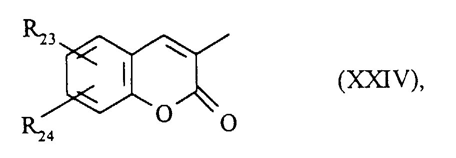 où R₂₃ et R₂₄ ont la même signification que dans la formule (XXIII), et
(c) un aminoacide de la formule (XXV) 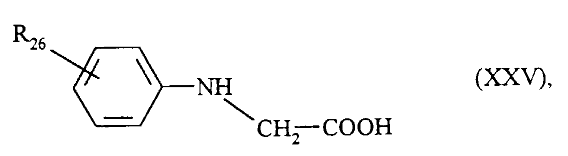 où R₂₆ est l'hydrogène, un groupe méthyle, éthyle, i-propyle, t-butyle, phényle, méthoxy, éthoxy, hydroxy, hydroxyméthyle, diméthylamino, diéthylamino, acétyle, propionyle, acétyloxy, propionyloxy, -NHCONH₂ ou -NHCOOCH₃ et éventuellement
(d) un ester d'acide acrylique ou méthacrylique de polyols aromatiques ou aliphatiques, un allyléther de polyols aromatiques ou aliphatiques ou un ester allylique d'acides polycarboxyliques aromatiques ou aliphatiques.

21. Composition contenant
(a) un polymère contenant des éléments structurels répétitifs de la formule (I) selon la revendication 1,
(b) une coumarine de la formule (XXIII) selon la revendication 20,
(c) une oxazolone de la formule (XXVI) 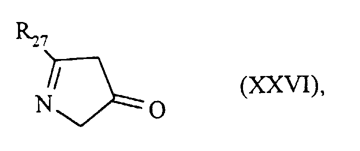 où R₂₇ est un groupe des formules (XXVII) ou (XXVIII) 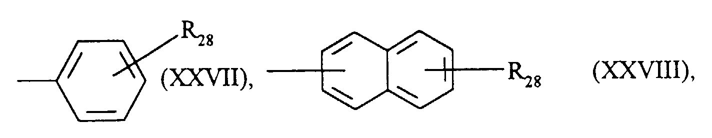 où R₂₈ est l'hydrogène, un groupe méthyle, éthyle, n-propyle, i-propyle, n-butyle, t-butyle, phényle, hydroxy, méthoxy, éthoxy, n-propoxy, n-butoxy, phénoxy, benzyle, 2-phényléthyle, hydroxyméthyle, 2-hydroxyéthyle, acétyle, propionyle, acétyloxy, propionyloxy, aminométhyle, 2-aminoéthyle, méthylamino, diméthylamino, diéthylamino, -CONH₂, -CONHCH₃, -CON(CH₃)₂, -CONHC₂H₅ ou -CON(C₂H₅)₂, et éventuellement
(d) un ester d'acide acrylique ou méthacrylique de polyols aromatiques ou aliphatiques, un allyléther de polyols aromatiques ou aliphatiques ou un ester allylique d'acides polycarboxyliques aromatiques ou aliphatiques.

## Revendications (Revendications pour l'(les) Etat(s) contractant(s) suivant(s): DE, FR, GB, IT)

1. Procédé pour la préparation d'images en relief, comprenant les étapes suivantes :
(A) revêtement d'un substrat avec une composition photopolymérisable contenant un polymère (a) et un photoinitiateur (b),
(B) irradiation aux dimensions de l'image du substrat revêtu avec un rayonnement UV dans le domaine de la bande i (environ 360-370 nm),
(C) élimination des endroits non irradiés à l'aide d'un solvant et
(D) recuisson du matériau irradié et développé,
un progéniteur de polyimide contenant des éléments structurels répétitifs de la formule (I), 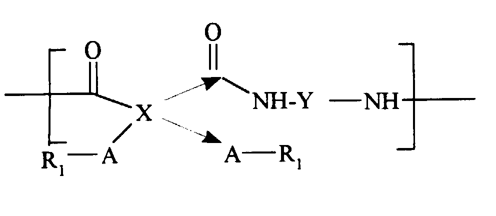 où → représente les isomères de structure, X représente le reste tétravalent d'un acide tétracarboxylique aromatique, Y est un reste bivalent aliphatique, cycloaliphatique ou aromatique mono- ou polycyclique, A est -COO-, -CONH- ou -COO^{⊖}HN^{⊕}R₂R₃-, où R₂ et R₃ sont indépendamment un groupe alkyle en C₁-C₆ ou alcényle en C₁-C₆, et R₁ est un reste avec une double liaison oléfinique photopolymérisable, étant utilisé comme polymère (a),
avec les proportions qu'au moins 50% de tous les restes X représentent le reste de l'acide oxydiphtalique ou qu'au moins 50% de tous les restes Y représentent un reste d'une diamine aromatique, qui est substituée à toutes les quatre positions ortho vers les deux atomes d'azote de l'amine indépendamment par un groupe alkyle en C₁-C₆, alcoxy en C₁-C₆ ou aryle en C₆ -C₁₄,
et un titanocène de la formule (XIV) ou une coumarine de la formule (XXIII) 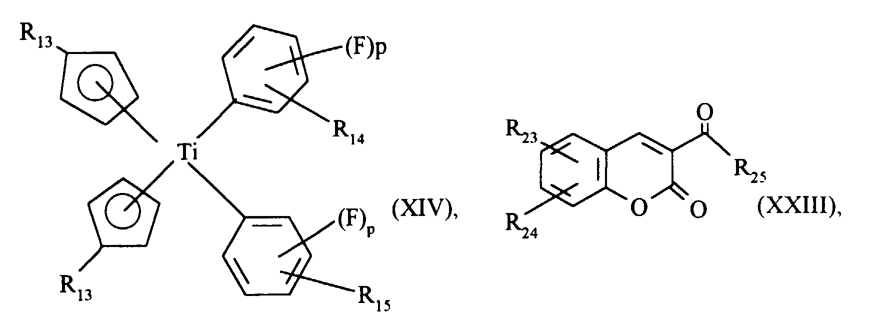 où les deux restes R₁₃ sont indépendamment l'hydrogène ou un groupe alkyle en C₁-C₆, R₁₄ et R₁₅ sont un groupe alkyle en C₁-C₆, aryle en C₆-C₁₄ ou un cycle hétérocyclique aliphatique pentagonal ou hexagonal ou aromatique et p est un nombre de 2 à 5, étant utilisé comme constituant (b),
avec les proportions qu'à chaque fois deux atomes de fluor occupent les positions ortho des deux cycles phényle;
où R₂₃ et R₂₄ sont indépendamment l'hydrogène ou un groupe alcoxy en C₁-C₆ et R₂₅ un groupe aryle en C₆-C₁₄ ou un reste de la formule (XXIV) 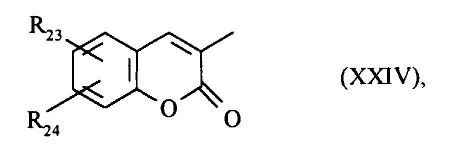 où R₂₃ et R₂₄ ont la même signification que dans la formule (XXIII).

2. Procédé selon la revendication 1, caractérisé en ce que l'on utilise comme polymère (a) un progéniteur de polyimide contenant des éléments structurels répétitifs de la formule (I), où au moins 50% de tous les restes X représentent le reste de l'acide oxydiphtalique et Y a la même signification que dans la revendication 1.

3. Procédé selon la revendication 1, caractérisé en ce que l'on utilise comme polymère (a) un progéniteur de polyimide contenant des éléments structurels répétitifs de la formule (I), où au moins 80% de tous les restes X représentent le reste de l'acide oxydiphtalique.

4. Procédé selon la revendication 1, caractérisé en ce que l'on utilise comme polymère (a) un progéniteur de polyimide contenant des éléments structurels répétitifs de la formule (I), où 100% de tous les restes X représentent le reste de l'acide oxydiphtalique.

5. Procédé selon la revendication 1, caractérisé en ce que l'on utilise comme polymère (a) un progéniteur de polyimide contenant des éléments structurels répétitifs de la formule (I), où A est -COO- et R₁ est un groupe vinyle, allyle, méthallyle ou un reste de la formule (II) 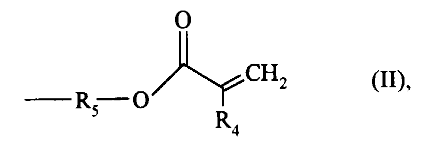 où R₄ est l'hydrogène ou un groupe méthyle et R₅ est -CₙH₂ₙ- avec n = 2-12, -CH₂CH(OH)CH₂- ou un polyoxyalkylène avec 4-30 atomes de carbone.

6. Procédé selon la revendication 2, caractérisé en ce que l'on utilise comme polymère (a) un progéniteur de polyimide contenant des éléments structurels répétitifs de la formule (I), où Y est un reste des formules (III)-(V) 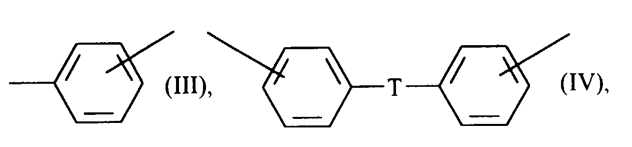 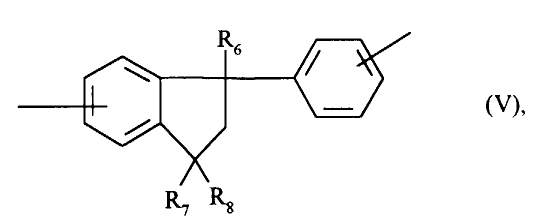 non substitué ou substitué par un ou plusieurs groupes alkyle en C₁-C₆ ou groupes alcoxy en C₁-C₆,où T est une liaison directe, -CH₂-, un groupe alkylidène en C₂-C₁₂, -C(CF₃)₂-, -NH-, -S-, -O-, -SO-, -SO₂- ou -CO- et R₆, R₇ et R₈ sont indépendamment l'hydrogène ou un groupe alkyle en C₁-C₆.

7. Procédé selon la revendication 2, caractérisé en ce que l'on utilise comme polymère (a) un progéniteur de polyimide contenant des éléments structurels répétitifs de la formule (I), où Y est un reste des formules (VI)-(VIII)

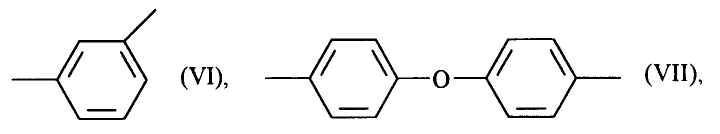

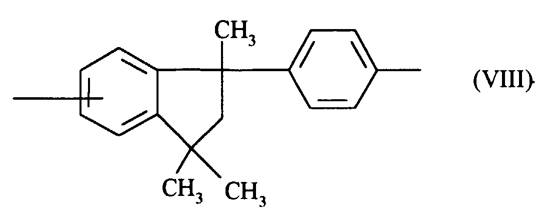

8. Procédé selon la revendication 1, caractérisé en ce que l'on utilise comme polymère (a) un progéniteur de polyimide contenant des éléments structurels répétitifs de la formule (I), où au moins 50% de tous les restes Y représentent un reste d'une diamine aromatique, qui est substituée à toutes les quatre positions ortho vers les deux atomes d'azote de l'amine indépendamment par un groupe alkyle en C₁-C₆, alcoxy en C₁-C₆ ou aryle en C₆-C₁₄, et X a la même signification que dans la revendication 1.

9. Procédé selon la revendication 1, caractérisé en ce que l'on utilise comme polymère (a) un progéniteur de polyimide contenant des éléments structurels répétitifs de la formule (I), où au moins 80% de tous les restes Y représentent un reste d'une diamine aromatique, qui est substituée à toutes les quatre positions ortho vers les deux atomes d'azote de l'amine indépendamment par un groupe alkyle en C₁-C₆, alcoxy en C₁-C₆ ou aryle en C₆-C₁₄.

10. Procédé selon la revendication 1, caractérisé en ce que l'on utilise comme polymère (a) un progéniteur de polyimide contenant des éléments structurels répétitifs de la formule (I), où 100% des restes Y représentent un reste d'une diamine aromatique, qui est substituée à toutes les quatre positions ortho vers les deux atomes d'azote de l'amine indépendamment par un groupe alkyle en C₁-C₆, alcoxy en C₁-C₆ ou aryle en C₆-C₁₄.

11. Procédé selon la revendication 8, caractérisé en ce que l'on utilise comme polymère (a) un progéniteur de polyimide contenant des éléments structurels répétitifs de la formule (I), où Y est un reste des formules (IX), (X) ou (XI) 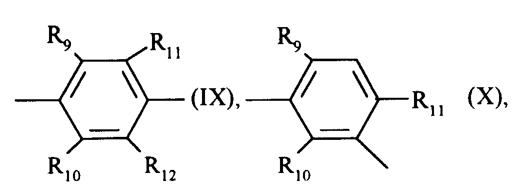 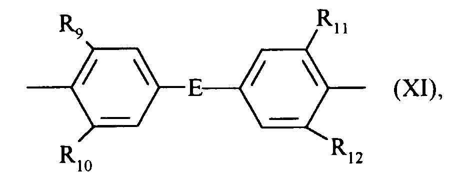 où R₉, R₁₀, R₁₁ et R₁₂ sont indépendamment un groupe alkyle en C₁-C₆ et E est une liaison directe, -CH₂-, un groupe alkylidène en C₂-C₁₂, -C(CF₃)₂-, -NH-, -S-, -O-, -SO-, -SO₂- ou -CO-.

12. Procédé selon la revendication 8, caractérisé en ce que l'on utilise comme polymère (a) un progéniteur de polyimide contenant des éléments structurels répétitifs de la formule (I), où Y est

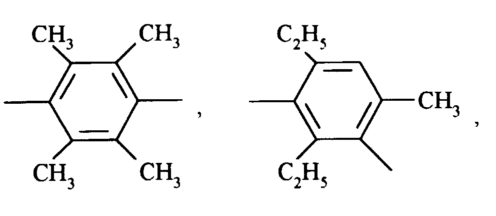

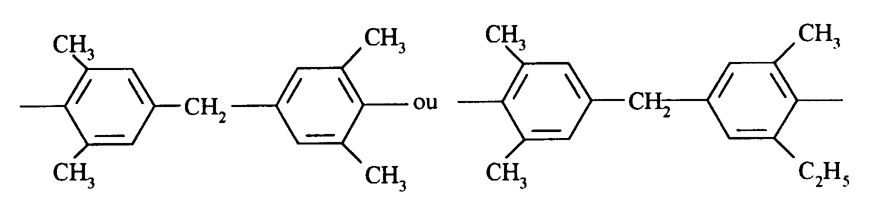

13. Procédé selon la revendication 8, caractérisé en ce que l'on utilise comme polymère (a) un progéniteur de polyimide contenant des éléments structurels répétitifs de la formule (I), où X est le reste de l'acide pyroméllitique, de l'acide 3,3',4,4'-biphényltétracarboxylique, de l'acide oxydiphtalique, de l'acide 3,3',4,4'-benzophénonetétracarboxylique ou de l'acide hexafluoroisopropylidènediphtalique.

14. Composition contenant
(a) un polymère contenant des éléments structurels répétitifs de la formule (I) selon la revendication 1, et
(b) un titanocène de la formule (XIV) 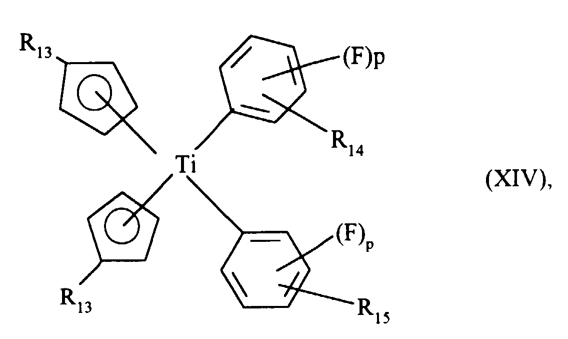 où les deux restes R₁₃ sont indépendamment l'hydrogène ou un groupe alkyle en C₁-C₆, R₁₄ et R₁₅ sont un groupe alkyle en C₁-C₆, aryle en C₆-C₁₄ ou un cycle hétérocyclique aliphatique pentagonal ou hexagonal ou aromatique et p est un nombre de 2 à 5, avec les proportions qu'à chaque fois deux atomes de fluor occupent les positions ortho des deux cycles phényle.

15. Composition selon la revendication 14 contenant comme constituant (b) un titanocène des formules (XV)-(XVIII)

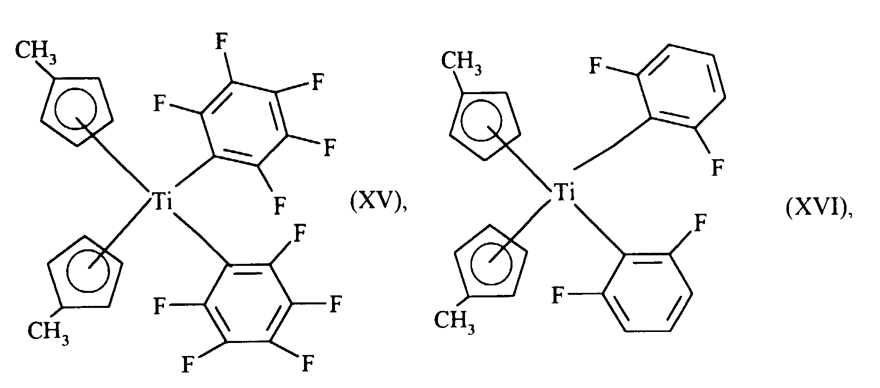

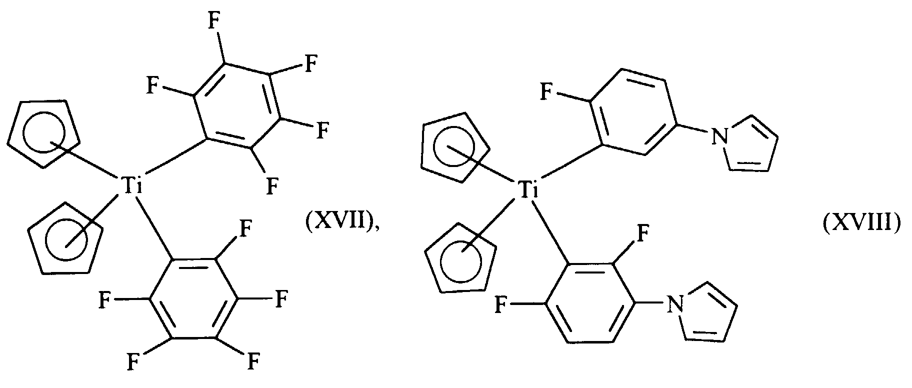

16. Composition selon la revendication 14, contenant en outre
(c) un ester d'acide acrylique ou méthacrylique de polyols aromatiques ou aliphatiques, un allyléther de polyols aromatiques ou aliphatiques ou un ester allylique d'acides polycarboxyliques aromatiques ou aliphatiques.

17. Composition contenant
(a) un polymère contenant des éléments structurels répétitifs de la formule (I) selon la revendication 1,
(b) un ester de tricétoxime de la formule (XX) 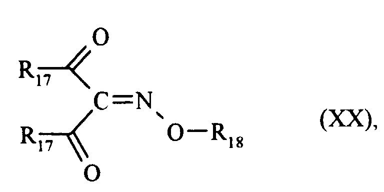 où les restes R₁₇ sont indépendamment un groupe p-tolyle, p-alcoxyphényle ou mésityle et R₁₈ est un groupe alkylcarbonyle en C₁-C₆, alcoxycarbonyle en C₁-C₆, arylcarbonyle en C₆-C₁₄ ou aryloxycarbonyle en C₆ -C₁₄, et
(c) un ester d'acide acrylique ou méthacrylique de polyols aromatiques ou aliphatiques, un allyléther de polyols aromatiques ou aliphatiques ou un ester allylique d'acides polycarboxyliques aromatiques ou aliphatiques.

18. Composition selon la revendication 17, contenant en outre
(d) une amine aromatique de la formule (XXI) 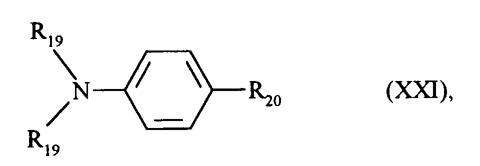 où les deux R₁₉ sont indépendamment un groupe alkyle en C₁-C₃ ou hydroxyalkyle en C₁-C₃ ou forment ensemble avec l'atome N un groupe morpholine et R₂₀ représente un groupe alkyle en C₁-C₃, alkylcarbonyle en C₂ -C₅ ou arylcarbonyle en C₇-C₁₀.

19. Composition selon la revendication 18, contenant en outre
(e) une coumarine de la formule (XXII) 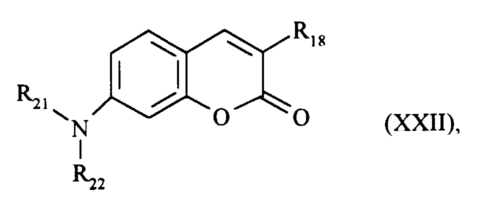 où R₂₁ et R₂₂ sont indépendamment des groupes alkyle en C₁-C₆ et R₁₈ est un groupe alkylcarbonyle en C₁-C₆, alcoxycarbonyle en C₁-C₆, arylcarbonyle en C₆-C₁₄ ou aryloxycarbonyle en C₆-C₁₄.

20. Composition contenant
(a) un polymère contenant des éléments structurels répétitifs de la formule (I) selon la revendication 1,
(b) une coumarine de la formule (XXIII) 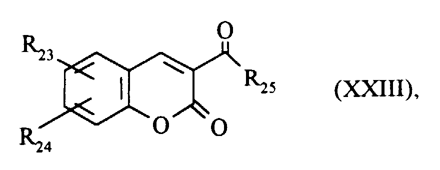 où R₂₃ et R₂₄ sont indépendamment l'hydrogène ou un groupe alcoxy en C₁-C₆ et R₂₅ est un groupe aryle en C₆-C₁₄ ou un reste de la formule (XXIV) 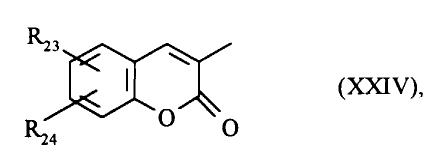 où R₂₃ et R₂₄ ont la même signification que dans la formule (XXIII), et
(c) un aminoacide de la formule (XXV) 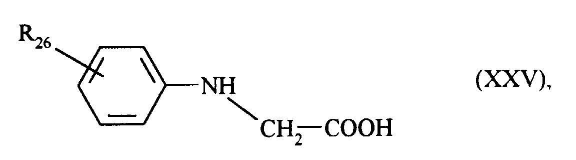 où R₂₆ est l'hydrogène, un groupe méthyle, éthyle, i-propyle, t-butyle, phényle, méthoxy, éthoxy, hydroxy, hydroxyméthyle, diméthylamino, diéthylamino, acétyle, propionyle, acétyloxy, propionyloxy, -NHCONH₂ ou -NHCOOCH₃ et éventuellement
(d) un ester d'acide acrylique ou méthacrylique de polyols aromatiques ou aliphatiques, un allyléther de polyols aromatiques ou aliphatiques ou un ester allylique d'acides polycarboxyliques aromatiques ou aliphatiques.

21. Composition contenant
(a) un polymère contenant des éléments structurels répétitifs de la formule (I) selon la revendication 1,
(b) une coumarine de la formule (XXIII) selon la revendication 20,
(c) une oxazolone de la formule (XXVI) 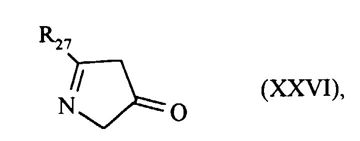 où R₂₇ est un groupe des formules (XXVII) ou (XXVIII) 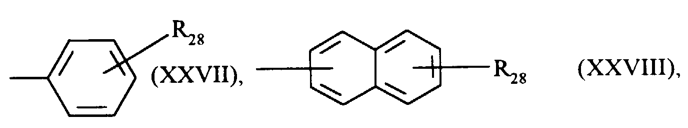 où R₂₈ est l'hydrogène, un groupe méthyle, éthyle, n-propyle, i-propyle, n-butyle, t-butyle, phényle, hydroxy, méthoxy, éthoxy, n-propoxy, n-butoxy, phénoxy, benzyle, 2-phényléthyle, hydroxyméthyle, 2-hydroxyéthyle, acétyle, propionyle, acétyloxy, propionyloxy, aminométhyle, 2-aminoéthyle, méthylamino, diméthylamino, diéthylamino, -CONH₂, -CONHCH₃, -CON(CH₃)₂, -CONHC₂H₅ ou -CON(C₂H₅)₂, et éventuellement
(d) un ester d'acide acrylique ou méthacrylique de polyols aromatiques ou aliphatiques, un allyléther de polyols aromatiques ou aliphatiques ou un ester allylique d'acides polycarboxyliques aromatiques ou aliphatiques.
